(19)

Europäisches
Patentamt
European
Patent Office
Office européen
des brevets

(11)  **EP 1 850 416 A1**

(12)  **EUROPEAN PATENT APPLICATION**

(43) Date of publication:
**31.10.2007 Bulletin 2007/44**

(51) Int Cl.:
*H01Q 17/00* (2006.01)     *H01R 4/04* (2006.01)
*H05K 9/00* (2006.01)

(21) Application number: **07008574.1**

(22) Date of filing: **26.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **28.04.2006 JP 2006126183**

(71) Applicant: **NITTO DENKO CORPORATION**
**Osaka (JP)**

(72) Inventor: **Niino, Takuya**
**Ibaraki-shi**
**Osaka (JP)**

(74) Representative: **Grünecker, Kinkeldey,**
**Stockmair & Schwanhäusser**
**Anwaltssozietät**
**Maximilianstrasse 58**
**80538 München (DE)**

(54)  **Adhesive tape having a characteristic of conducting or absorbing electromagnetic waves**

(57)     The present invention relates to a tape having a characteristic of conducting or absorbing electromagnetic waves, which comprises an adhesive layer; a powder material convex structure section having a characteristic of conducting or absorbing electromagnetic waves disposed on a surface of the adhesive layer, the powder material convex structure section containing a powder material having a characteristic of conducting or absorbing electromagnetic waves and being formed so as to have a convex structure; and a holding part disposed on a surface of the adhesive layer, the holding part holding the convex structure of the powder material convex structure section having a characteristic of conducting or absorbing electromagnetic waves.

*FIG. 1*

**Description**

FIELD OF THE INVENTION

The present invention relates to a structure having a characteristic of conducting or absorbing electromagnetic waves.

BACKGROUND OF THE INVENTION

In various kinds of joining (especially, joining of electronic parts) for which a pressure-sensitive adhesive tape is used, it has been frequently required to have a characteristic of conducting or absorbing electromagnetic waves such as an electrical conductivity and electromagnetic shielding properties. For that reason, with respect to a method for providing (realizing) a characteristic of conducting or absorbing electromagnetic waves such as electrical conductivity and electromagnetic shielding properties in a pressure-sensitive adhesive tape, there have hitherto been made a lot of investigations. For example, as materials having electrical conductivity or electromagnetic shielding properties, there are proposed an electrically conductive mutual connecting material obtained by a non-random single layer coating of a particle (see Patent Reference 1); an electrically conductive sealing material obtained by blending a silica powder, carbon black and a metal powder in a silicone rubber (see Patent Reference 2); and so on. As materials having electrical conductivity or electromagnetic shielding properties, there is also proposed a high molecular molded member having electromagnetic shielding properties in which flocks formed by electrically conductive fibers are flocked on a high molecular substrate and electrical conductivity is imparted between flocks at the roots of the flocks (see Patent Reference 3).
For the purpose of keeping electrical conductivity, it is required in the foregoing electrically conductive mutual connecting material that particles having electrical conductivity be regularly aligned. Such regular alignment of the particles, if possible, is certainly useful in view of the electrical conductivity, but such regular alignment of the particles is very complicated and is accompanied by difficulty in the process steps.
Furthermore, the foregoing electrically conductive sealing material is provided with an electrical conductivity by kneading particles having electrical conductivity into a resin of various kinds. For that reason, the preparation method in this case is simple, and there is less problems in view of process steps. However, in order to impart electrical conductivity, a large amount of the electrically conductive particles must be blended, and as a result, there was involved a defect that the costs become comparatively high. Moreover, since a large amount of the electrically conductive particles is blended, there is also involved a defect that other characteristics are affected.
In addition, since the foregoing high molecular molded member having electromagnetic shielding properties has a construction in which electrically conductive fibers are flocked on a high molecular substrate by using an adhesive layer having electrical conductivity, etc., the electromagnetic shielding properties are improved, but it cannot be said that such an improvement is sufficient. Thus, a structure having even better electromagnetic shielding properties is demanded.
Patent Reference 1: JP-T-2002-501821
Patent Reference 2: JP-A-10-120904
Patent Reference 3: JP-A-61-2394

SUMMARY OF THE INVENTION

Accordingly, an object of the present invention is to provide a structure that has a characteristic of conducting or absorbing electromagnetic waves at an excellent level and that can be produced easily and inexpensively.
Another object of the present invention is to provide a structure that can be advantageously utilized as an electrically conductive material, an electromagnetic absorbing material or an electromagnetic shielding material.
In order to achieve the foregoing objects, the present inventors have made extensive and intensive investigations. As a result, it has been found that, by depositing a metal powder so as to form a convex structure on the surface of a pressure-sensitive adhesive layer thereby forming a convex structure section by the metal powder, a member having such pressure-sensitive adhesive layer can be given an electrically conductive property and can also be produced easily and inexpensively. The invention has been accomplished on the basis of these findings.

BRIEF DESCRIPTION OF THE DRAWINGS

Fig. 1 is a partial schematic cross-sectional view illustrating an example of a structure of the present invention.
Figs. 2A and 2B are partial schematic views illustrating examples of holding part-constituting member to be employed in the structure of the present invention.

Fig. 3 is a partial schematic view illustrating an example of the holding part-constituting member to be employed in the structure of the present invention.

Figs. 4A to 4C are schematic cross-sectional views illustrating examples of the structure of the present invention.

Figs. 5A and 5B are schematic views illustrating shield boxes to be used in a KEC method electromagnetic shield evaluation system, and respectively illustrate an electric field shield box and a magnetic field shield box.

Description of Symbols

| | |
|---|---|
| 1: | structure |
| 1a: | substrate |
| 1a1: | surface of substrate 1a |
| 1b: | electromagnetic conducting or absorbing powder convex structure section |
| 1c: | holding part |
| 1d: | coating layer of structure |
| 21: | net-like member |
| 22: | net-like member |
| 21a: | penetrating hole section in net-like member 21 |
| 22a: | penetrating hole section in net-like member 22 |
| 23: | perforated sheet member |
| 231: | sheet-like substrate |
| 232: | penetrating hole section (perforation) formed by perforating work |
| 3a: | structure |
| 3a1: | pressure-sensitive adhesive or adhesive layer (pressure-sensitive adhesive layer or adhesive layer) |
| 3a2: | base material |
| 3a3: | electromagnetic conducting or absorbing powder convex structure section |
| 3a4: | holding part |
| 3a5: | coating layer |
| 3b: | structure |
| 3b1: | pressure-sensitive adhesive layer |
| 3b2: | release liner |
| 3b3: | electromagnetic conducting or absorbing powder convex structure section |
| 3b4: | holding part |
| 3b5: | coating layer |
| 3c: | structure |
| 3c1: | polymer layer |
| 3c2: | electromagnetic conducting or absorbing powder convex structure section |
| 3c3: | holding part |
| 3c4: | coating layer |

DETAILED DESCRIPTION OF THE INVENTION

Namely, the present invention relates to the followings.

(1) A structure having a characteristic of conducting or absorbing electromagnetic waves, which comprises:

a substrate;
a powder material convex structure section having a characteristic of conducting or absorbing electromagnetic waves disposed on a surface of the substrate, said powder material convex structure section containing a powder material having a characteristic of conducting or absorbing electromagnetic waves and being formed so as to have a convex structure; and
a holding part disposed on a surface of the substrate, said holding part holding the convex structure of the powder material convex structure section having a characteristic of conducting or absorbing electromagnetic waves.

(2) The structure according to (1), having a construction in which the powder material convex structure section having a characteristic of conducting or absorbing electromagnetic waves and the holding part are formed on a surface of the substrate, which is formed by adhering a member having a penetrating hole section on the surface of the substrate thereby forming the holding part; then introducing the powder material having a characteristic of conducting or absorbing electromagnetic waves into the penetrating hole section of the member having a penetrating hole section, thereby forming the powder material convex structure section having a characteristic of conducting or absorbing electromagnetic waves; and then covering, with a coating layer, the surface on which the powder material convex structure section having a characteristic of conducting or absorbing electromagnetic waves is exposed.

(3) The structure according to (2), wherein the member having a penetrating hole section is a member having a plurality of penetrating hole sections in a net-like form, or a sheet-like member having a plurality of penetrating hole sections formed by perforation.

(4) The structure according to (1), having a construction in which the powder material convex structure section having a characteristic of conducting or absorbing electromagnetic waves and the holding part are formed on a surface of the substrate, which is formed by introducing the powder material having a characteristic of conducting or absorbing electromagnetic waves into a concave of a member having a concave employed as the holding part, thereby forming the powder material convex structure section having a characteristic of conducting or absorbing electromagnetic waves; and then covering, with the substrate, the surface on which the powder material convex structure section having a characteristic of conducting or absorbing electromagnetic waves is exposed.

(5) The structure according to any one of (1) to (4), wherein the holding part includes a plastic material.

(6) The structure according to any one of (1) to (5), wherein a total area of a portion of the surface of the substrate on which the powder material convex structure section having a characteristic of conducting or absorbing electromagnetic waves is formed has a proportion more than 0% but equal to or less than 99.9% with respect to a total surface area of one side of the substrate.

(7) The structure according to any one of (1) to (6), wherein the substrate is at least one member selected from the group consisting of a pressure-sensitive adhesive layer, an adhesive layer and a polymer layer.

(8) The structure according to any one of (1) to (7), wherein the substrate has a characteristic of conducting or absorbing electromagnetic waves.

(9) The structure according to any one of (1) to (8), wherein the substrate is formed on at least one surface of a support.

(10) The structure according to (9), wherein the support has a characteristic of conducting or absorbing electromagnetic waves.

(11) The structure according to any one of (1) to (10), which is a sheet-like structure having a sheet-like form.

(12) The structure according to any one of (1) to (11), which is used as an electrically conductive member.

(13) The structure according to any one of (1) to (11), which is used as an electromagnetic absorbing member.

(14) The structure according to any one of (1) to (11), which is used as an electromagnetic shielding member.

The structure of the present invention preferably has a construction in which a powder material convex structure section having a characteristic of conducting or absorbing electromagnetic waves and a holding part are formed on a surface of a substrate, by adhering a member having a penetrating hole section on a surface of the substrate thereby forming the holding part; then introducing the powder material having a characteristic of conducting or absorbing electromagnetic waves into the penetrating hole section of the member having a penetrating hole section, thereby forming the powder material convex structure section having a characteristic of conducting or absorbing electromagnetic waves; and then covering the surface on which the powder material convex structure section having a characteristic of conducting or absorbing electromagnetic waves is exposed with a coating layer. In this case, the member having a penetrating hole section is preferably a member having a plurality of penetrating hole sections in a net-like form, or a sheet-like member having a plurality of penetrating hole sections formed by perforation.

Further, the structure of the invention preferably has a construction in which a powder material convex structure section having a characteristic of conducting or absorbing electromagnetic waves and a holding part are formed on a surface of a substrate, by introducing the powder material having a characteristic of conducting or absorbing electromagnetic waves into a concave of a member having a concave employed as the holding part, thereby forming the powder material convex structure section having a characteristic of conducting or absorbing electromagnetic waves; and then covering the surface on which the powder material convex structure section having a characteristic of conducting or absorbing electromagnetic waves is exposed with the substrate.

The material of the holding part is preferably a plastic material.

Further, a total area of a portion of the surface of the substrate where the powder material convex structure section having a characteristic of conducting or absorbing electromagnetic waves is formed preferably has a proportion more than 0% but equal to or less than 99.9% with respect to the total surface area of one side of the substrate.

The substrate is preferably at least one member selected from the group consisting of a pressure-sensitive adhesive layer, an adhesive layer and a polymer layer. The substrate preferably has a characteristic of conducting or absorbing electromagnetic waves. The substrate may be formed on at least one surface of a support, and the support preferably has a characteristic of conducting or absorbing electromagnetic waves.

Such structure is preferably a sheet-like structure having a sheet-like form.

The structure of the invention can be advantageously utilized as an electrically conductive member, an electromagnetic absorbing member or an electromagnetic shielding member.

The structure of the present invention, having the aforementioned construction, has a characteristic of conducting or absorbing electromagnetic waves at an excellent level and can be produced easily and inexpensively. Therefore, the structure of the present invention can be advantageously utilized as an electrically conductive material, an electromagnetic absorbing material or an electromagnetic shielding material.

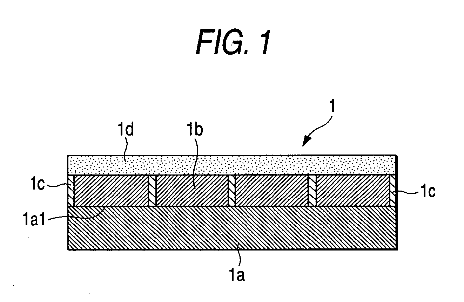

As illustrated in Fig. 1, the structure of the present invention has a construction that a powder material convex structure section having a characteristic of conducting or absorbing electromagnetic waves which is formed by a powder material having a characteristic of conducting or absorbing electromagnetic waves (hereinafter also called "electromagnetic conductive or absorbing powder") so as to have a convex structure (such structure section being hereinafter also called "electromagnetic conducting or absorbing powder convex structure section") and a holding part for holding the convex structure of the electromagnetic conducting or absorbing powder convex structure section are formed partially on a surface of a substrate. Thus, in the structure of the invention, the electromagnetic conducting or absorbing powder convex structure section is formed by holding the form of the convex structure of the electromagnetic conductive or absorbing powder by means of the holding part. Thus the structure of the invention, having the electromagnetic conducting or absorbing powder convex structure section, can exhibit properties of conducting or absorbing electromagnetic waves (hereinafter also called "electromagnetic conducting or absorbing properties") at an excellent level. Besides, since the electromagnetic conducting or absorbing powder convex structure section is formed in a form held by the holding part, the structure of the invention can be produced easily and inexpensively.

Fig. 1 is a schematic partial cross-sectional view illustrating an example of the structure of the invention. Referring to Fig. 1, there are illustrated a structure 1, a substrate 1a, a surface 1a1 of the substrate 1a, an electromagnetic conducting or absorbing powder convex structure section 1b, a holding part 1c, and a coating layer 1d. The structure 1 illustrated in Fig. 1 has a construction, in which an electromagnetic conducting or absorbing powder convex structure section 1b is formed partially on the surface 1a1 of the substrate 1a, and a holding part 1c is formed on a part of the surface 1a1 of the substrate 1 where the electromagnetic conducting or absorbing powder convex structure section is not formed. Further, in the structure 1 illustrated in Fig. 1, a coating layer 1d is formed on a surface on which the electromagnetic conducting or absorbing powder convex structure section 1b and the holding part 1c are formed, and the electromagnetic conducting or absorbing powder convex structure section 1b is formed by enclosing (sealing) the electromagnetic conductive or absorbing powder within a space surrounded by the substrate 1a, the holding part 1c and the coating layer 1d.

Electromagnetic conducting or absorbing powder convex structure section

In the structure of the invention, the electromagnetic conducting or absorbing powder convex structure section is formed, as described above, partially on the surface of the substrate, with a electromagnetic conductive or absorbing powder so as to form a convex structure. The electromagnetic conducting or absorbing powder convex structure section may be any structure section that is formed with an electromagnetic conductive or absorbing powder with a form of a convex structure and that has electromagnetic conducting or absorbing properties, and examples of such electromagnetic conducting or absorbing powder convex structure section include an electromagnetic conducting or absorbing powder convex structure section having a columnar (rod-like) structure, an electromagnetic conducting or absorbing powder convex structure section having a structure of a substantially conical form or a substantially polygonal conical form (such as substantially triangular conical form or substantially tetragonal conical form) and an electromagnetic conducting or absorbing powder convex structure section having a structure of a substantially inverted conical form or a substantially inverted polygonal conical form (such as substantially inverted triangular conical form or substantially inverted tetragonal conical form). Thus, the electromagnetic conducting or absorbing powder convex structure section may have, as a cross-sectional form when sectioned in a direction parallel to the substrate surface, any of a constant form, a form varying continuously under a specified condition, or an amorphous form.

In the invention, the electromagnetic conducting or absorbing powder convex structure section may be constituted of a single structure or of a structure formed by a combination of plural structures.

Incidentally, a single electromagnetic conducting or absorbing powder convex structure section is ordinarily constituted of plural electromagnetic conductive or absorbing powders. A number and a density of the electromagnetic conductive or absorbing powders constituting the single electromagnetic conducting or absorbing powder convex structure section are not particularly restricted, and may be appropriately selected for example according to the desired electromagnetic conducting or absorbing properties.

The electromagnetic conducting or absorbing powder convex structure section is advantageously an electromagnetic conducting or absorbing powder convex structure section having a columnar (rod-like) structure (also called "electromagnetic conducting or absorbing powder columnar convex structure section"). In the electromagnetic conducting or absorbing powder columnar convex structure section, the cross-sectional shape of the columnar structure may be any of a substantially circular shape (such as a circular shape or an oval shape), a substantially polygonal shape (such as a substantially triangular shape, a substantially tetragonal shape, a substantially pentagonal shape, a substantially hexagonal shape, or a substantially octagonal shape), or an amorphous shape, but is advantageously a substantially circular shape (such as a circular shape or an oval shape), or a substantially polygonal shape (such as a substantially tetragonal shape).

The electromagnetic conducting or absorbing powder convex structure section is disposed partially on the substrate surface, and the shape as a whole is not particularly limited, but it may have a prescribed pattern shape.

The total area of a portion of the surface of the substrate on which the electromagnetic conducting or absorbing powder convex structure section is provided (area of the whole electromagnetic conducting or absorbing powder convex structure sections) is not particularly limited, but, in consideration of the electromagnetic conducting or absorbing properties, it preferably has a proportion more than 0% and equal to or less than 99.9% with respect to the total surface area of one side of the substrate. The area of the whole electromagnetic conducting or absorbing powder convex structure sections may be suitably selected, for example, according to the purpose of the structure or a size of the surface area on one surface of the structure. Specifically, in the case that the structure of the invention is utilized as an electromagnetic shield material for an electronic component (particularly an electronic component employed in so-called "mobile phone") or in the case that the structure has a limited surface area on one surface (for example a surface area of 500 mm$^2$ or less), the area of the whole electromagnetic conducting or absorbing powder convex structure sections is preferably from 0.3 to 99.8%, more preferably from 30 to 90% and particularly preferably from 45 to 80%. Further, in the case that the structure of the invention is utilized as an electromagnetic shield material for a building (for example use by adhesion to members constituting various surfaces (such as a wall surface, a ceiling surface, a floor surface and the like) of a building, by adhesion in advance to a construction material (such as boards or flooring materials) or in the case that the structure has a large surface area on one surface (for example a surface area of 0.5 m$^2$ or larger), the area of the whole electromagnetic conducting or absorbing powder convex structure sections is preferably from 0.03 to 99.8%, more preferably from 0.1 to 50% and particularly preferably from 0.3 to 40%. In the case that the area of the whole electromagnetic conducting or absorbing powder convex structure sections on the substrate surface is excessively low with respect to the total surface area on one side of the substrate, the electromagnetic conducting or absorbing properties are deteriorated. On the other hand, in the case that the area of the whole electromagnetic conducting or absorbing powder convex structure sections on the substrate surface exceeds 99.9% with respect to the total surface area on one side of the substrate, a proportion of the site where the holding part is provided becomes low, whereby the holding property for electromagnetic conducting or absorbing powder convex structure section may be deteriorated.

Also, the area of each electromagnetic conducting or absorbing powder convex structure section on the substrate surface or the shortest distance between the electromagnetic conducting or absorbing powder convex structure sections are not particularly restricted.

Incidentally, the area of the electromagnetic conducting or absorbing powder convex structure section on the substrate surface is usually an area of a portion of the surface of the substrate where the electromagnetic conducting or absorbing powder convex structure section is formed, but, when the electromagnetic conducting or absorbing powder convex structure section, for example, has a substantially inverted conical shape or a substantially inverted polygonal conical shape, it may be an area matching or corresponding to a planar shape (for example an upper surface shape) of the electromagnetic conducting or absorbing powder convex structure section seen from the surface where the electromagnetic conducting or absorbing powder convex structure section is formed.

Such electromagnetic conducting or absorbing powder convex structure section can be constructed of a electromagnetic conductive or absorbing powder. The electromagnetic conductive or absorbing powder is not particularly restricted, and it may be a powder in which a powder raw material itself has electromagnetic conducting or absorbing properties (hereinafter also called "electromagnetic conducting or absorbing raw material powder") or may be a powder in which electromagnetic conducting or absorbing properties are imparted to the powder raw material by an electromagnetic conducting or absorbing material (hereinafter also called "electromagnetic conducting or absorbing properties-imparted powder"). The electromagnetic conducting or absorbing powder may be used singly or in a combination of two or more kinds thereof.

In the electromagnetic conducting or absorbing powder, a powder material constituted of a material in which the powder raw material itself has electromagnetic conducting or absorbing properties can be used as the electromagnetic conducting or absorbing raw material powder. Examples of the electromagnetic conducting or absorbing raw material powder include a carbon-based powder, a powder material made of an electrically conductive polymer and a metallic powder material. Examples of the carbon-based powder include a powder made of a carbon-based raw material such as carbon black. Also, the electrically conductive polymer in the powder material made of an electrically conductive polymer is not particularly limited, and examples thereof include a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer. In addition, the metallic powder is not particularly limited, and it can be properly selected among powder materials made of a metal material as specifically enumerated below. Specific examples of the metallic powder include powder materials made of a metal element such as a gold powder, a silver powder, an aluminum powder, an iron powder, a copper powder, a nickel powder, a stainless steel-based powder, and a copper-nickel alloy powder, and powder materials made of a metallic compound of any type containing a metal element and a non-metal element such as a copper sulfide powder.

Furthermore, in the electromagnetic conductive or absorbing powder, the electromagnetic conducting or absorbing properties-imparted powder is not particularly restricted so far as it is a powder in which electromagnetic conducting or absorbing properties are imparted by an electromagnetic conducting or absorbing material. Examples thereof include a powder coated by an electromagnetic conducting or absorbing material (hereinafter also called "electromagnetic conducting or absorbing material-coated powder"); a powder having an electromagnetic conducting or absorbing material impregnated therein (hereinafter also called "electromagnetic conducting or absorbing material-impregnated powder"); and a powder containing an electromagnetic conducting or absorbing material in a powder raw material (hereinafter also called "electromagnetic conducting or absorbing material-containing raw material powder").

As the electromagnetic conducting or absorbing properties-imparted powder, an electromagnetic conducting or absorbing material-coated powder can be used advantageously. In the electromagnetic conducting or absorbing material-coated powder as the electromagnetic conducting or absorbing properties-imparted powder, a powder (powder raw material) before the electromagnetic conducting or absorbing properties are imparted by the electromagnetic conducting or absorbing material is not particularly limited, and may be either of an organic powder and an inorganic powder. Also, the powder raw material may be an electromagnetic conducting or absorbing powder or may be a powder material not having the electromagnetic conducting or absorbing properties. More specifically, examples of the powder raw material include organic powders such as a polyamide-made powder, a polyester-made powder, a polyacrylonitrile-made powder, an acrylic resin-made powder, a polyvinyl alcohol-made powder, a polyethylene-made powder, a polyimide-made powder, a polyolefin resin-made powder, a silicone resin-made powder, and a fluorinated resin-made powder; and inorganic powders such as a crushed stone powder. As the powder raw material, an organic powder is preferable. The powder raw material may be used singly or in a combination of two or more kinds.

Moreover, in the electromagnetic conducting or absorbing material-coated powder as the electromagnetic conducting or absorbing properties-imparted powder, the electromagnetic conducting or absorbing material is not particularly limited. For example, in addition to a metal material and a plastic material having electromagnetic conducting or absorbing properties (hereinafter also called "electromagnetic conducting or absorbing plastic material"), a magnetic material of various types can be used. Of these, a metal material can be used advantageously. The electromagnetic conducting or absorbing material can be used singly or in a combination of two or more kinds. In the electromagnetic conducting or absorbing material-coated powder, the metal material may be a metal material formed by metal elements only such as a metal element or an alloy, or may be a metallic compound of various types containing a non-metal element together with a metal element. As the metal material, a metal material formed solely of metal elements is suitable. Concretely, examples of the metal element in the metal material formed by a metal element only include an element belonging to the Group 1 of the periodic table such as lithium, sodium, potassium, rubidium, and cesium; an element belonging to the Group 2 of the periodic table such as magnesium, calcium, strontium, and barium; an element belonging to the Group 3 of the periodic table such as scandium, yttrium, a lanthanoid element (such as lanthanum and cerium), and an actinoid element (such as actinium); an element belonging to the Group 4 of the periodic table such as titanium, zirconium, and hafnium; an element belonging to the Group 5 of the periodic table such as vanadium, niobium, and tantalum; an element belonging to the Group 6 of the periodic table such as chromium, molybdenum, and tungsten; an element belonging to the Group 7 of the periodic table such as manganese, technetium, and rhenium; an element belonging to the Group 8 of the periodic table such as iron, ruthenium, and osmium; an element belonging to the Group 9 of the periodic table such as cobalt, rhodium, and iridium; an element belonging to the Group 10 of the periodic table such as nickel, palladium, and platinum; an element belonging to the Group 11 of the periodic table such as copper, silver, and gold; an element belonging to the Group 12 of the periodic table such as zinc, cadmium, and mercury; an element belonging to the Group 13 of the periodic table such as aluminum, gallium, indium, and thallium; an element belonging to the Group 14 of the periodic table such as tin and lead; and an element belonging to the Group 15 of the periodic table such as antimony and bismuth). On the other hand, examples of the alloy include stainless steel, a copper-nickel alloy, brass, a nickel-chromium alloy, an iron-nickel alloy, a zinc-nickel alloy, a gold-copper alloy, a tin-lead alloy, a silver-tin-lead alloy, a nickel-chromium-iron alloy, a copper-manganese-nickel alloy, and a nickel-manganese-iron alloy.

Furthermore, the metallic compound containing a non-metal element together with a metal element is not particularly limited so far as it is a metallic compound containing a metal element or an alloy as enumerated previously and capable of exhibiting electromagnetic conducting or absorbing properties. Examples thereof include metal sulfides such s copper sulfide; metal oxides and complex metal oxides such as iron oxide, titanium oxide, tin oxide, indium oxide, and cadmium tin oxide.

Concretely, as the metal material, gold, silver, aluminum, iron, copper, nickel, stainless steel, and a copper-nickel alloy can be advantageously used. In particular, gold, silver, aluminum, copper, nickel, and a copper-nickel alloy can be used advantageously.

Incidentally, examples of the electromagnetic conducting or absorbing plastic material include an electrically conductive plastic material such as a polyacetylene-based conductive polymer, a polypyrrole-based conductive polymer, a polyacene-based conductive polymer, a polyphenylene-based conductive polymer, a polyaniline-based conductive polymer, and a polythiophene-based conductive polymer.

In addition, the magnetic material is not particularly limited, and examples thereof include a soft magnetic powder, various ferrites, and a zinc oxide whisker. As the magnetic material, a ferromagnetic material exhibiting ferromagnetism or ferrimagnetism is suitable. Specific examples of the magnetic material include high-magnetic permeability ferrite (for example so-called "soft ferrite" such as so-called "Mn ferrite", so-called "Ni ferrite", so-called "Zn ferrite", so-called "Mn-Zn ferrite", and so-called "Ni-Zn ferrite"), pure iron, silicon atom-containing iron (such as so-called "silicon steel"), a nickel-iron alloy (for example, so-called "permalloy", a nickel-manganese-iron alloy, a nickel-molybdenum-copper-iron alloy, and a nickel-molybdenum-manganese-iron alloy), an iron-cobalt alloy, an amorphous metal high-magnetic permeability material, an iron-aluminum-silicon alloy (such as so-called "Sendust alloy"), an iron-aluminum-silicon-nickel alloy (such as so-called "Super Sendust alloy"), so-called "ferrite magnet" (for example so-called "hard ferrite", so-called "Ba ferrite" and so-called "Sr ferrite"), so-called "Alnico magnet" (such as an iron-nickel-aluminum-cobalt alloy), an iron-chromium-cobalt alloy, so-called "rare earth cobalt magnet" (such as so-called "Sm-Co magnet" and co-called "2-17 type magnet"), so-called "Nd-Fe-B magnet", so-called "rare earth-iron-nitrogen interstitial compound magnet", and so-called "Mn-Al-C magnet".

In the electromagnetic conducting or absorbing material-coated powder, a method for coating an electromagnetic conducting or absorbing material on a powder raw material is not particularly limited, and a known coating method can be properly selected and applied depending upon the type of the electromagnetic conducting or absorbing material. For example, in the case where the electromagnetic conducting or absorbing material is a metal material, as a method for forming the electromagnetic conducting or absorbing material-coated powder, a coating method by vapor deposition of a metal material or a coating method by plating of a metal material are suitable.

Furthermore, in the electromagnetic conducting or absorbing material-impregnated powder as the electromagnetic conducting or absorbing properties-imparted powder, an electromagnetic conducting or absorbing material (for example, a metal material, an electromagnetic conducting or absorbing plastic material, and a magnetic material) same as the electromagnetic conducting or absorbing material in the foregoing electromagnetic conducting or absorbing material-coated powder can be used as the electromagnetic conducting or absorbing material, and a metal material (in particular, gold, silver, aluminum, copper, nickel, and a copper-nickel alloy) can be used advantageously. In the electromagnetic conducting or absorbing material-impregnated powder, a method for impregnating the powder raw material with the electromagnetic conducting or absorbing material is not particularly limited, and a known impregnation method can be properly selected and applied depending upon the type of the electromagnetic conducting or absorbing material. For example, in the case where the electromagnetic conducting or absorbing material is a metal material, as the method for forming the electromagnetic conducting or absorbing material-impregnated powder, an impregnation method of dipping the powder raw material into the metal material is advantageous.

Also, in the electromagnetic conducting or absorbing material-containing raw material powder as the electromagnetic conducting or absorbing properties-imparted powder, an electromagnetic conducting or absorbing material (for example, a metal material, an electromagnetic conducting or absorbing plastic material, and a magnetic material) same as the electromagnetic conducting or absorbing material in the foregoing electromagnetic conducting or absorbing material-coated powder can be used as the electromagnetic conducting or absorbing material, and a metal material (in particular, gold, silver, aluminum, copper, nickel, and a copper-nickel alloy) can be used advantageously. The electromagnetic conducting or absorbing material such as a metal material may have any form such as a powder form, a film form, a foil form, a thin layer form, and a fibrous form. Furthermore, as a material of the powder raw material in the electromagnetic conducting or absorbing material-containing raw material powder, a plastic material (for example, polyamide, polyester, polyacrylonitrile, an acrylic resin, polyvinyl alcohol, polyethylene, polyimide, a polyolefin-based resin, a silicone-based resin, and a fluorine-based resin) can be used advantageously. In the electromagnetic conducting or absorbing material-containing raw material powder, a method for including the electromagnetic conducting or absorbing material in the powder raw material is not particularly limited, and a known including method can be properly selected and applied depending upon the type of the electromagnetic conducting or absorbing material. For example, there can be employed a method for including the electromagnetic conducting or absorbing material in the powder raw material by mixing a material of the powder raw material with the electromagnetic conducting or absorbing material for example by kneading, and then powderizing the mixture.

In the invention, the electromagnetic conductive or absorbing powder may be used in a powder form as it is, or in a dispersed form (such as a slurry-like form) or in a dissolved form. Examples of a electromagnetic conductive or absorbing powder composition in a dispersed form include a form of a metal paste, in which a metal powder is dispersed in a binder component.

Such electromagnetic conductive or absorbing powder (or powder raw material) is not particularly restricted in a particle size, so far as the particle size can realize a powdery state. Also the electromagnetic conductive or absorbing powder (or powder raw material) may have any particle shape such as an atomized shape (spherical shape), a flake shape, an acicular shape or a dendrite-like (tree-like) shape.

Incidentally, as the electromagnetic conducting or absorbing powder, plural, or two or more, kinds of electromagnetic conducting or absorbing powders or an electromagnetic conducting or absorbing powder utilizing plural, or two or more, kinds of electromagnetic conducting or absorbing materials is preferably used. In particular, plural, or two or more, kinds of electromagnetic conducting or absorbing powders can be employed advantageously. Such plural, or two or more, kinds of electromagnetic conducting or absorbing materials employed in the electromagnetic conducting or absorbing powder allow to obtain a structure matching a wide range of electromagnetic waves as described below.

A method for forming the electromagnetic conducting or absorbing powder convex structure section is not particularly restricted, but a forming method utilizing, as a member for forming the holding part, a member having a penetrating hole section or a member having a concave can be used advantageously. Specifically, in case of formation with a member having a penetrating hole section, it is preferable that a member having a penetrating hole section is adhered in advance on a prescribed position of the substrate surface corresponding to the prescribed portion of the substrate surface where the electromagnetic conducting or absorbing powder convex structure section is to be formed, and then an electromagnetic conductive or absorbing powder is introduced into the penetrating hole section of the member having a penetrating hole section, thereby forming an electromagnetic conducting or absorbing powder convex structure section. In case of using the electromagnetic conductive or absorbing powder as it is in a powder form, the electromagnetic conducting or absorbing powder convex structure section can be formed by introducing and depositing the electromagnetic conductive or absorbing powder into the penetrating hole section of the member having a penetrating hole section. Also in case of using the electromagnetic conductive or absorbing powder in a dispersed form, the electromagnetic conducting or absorbing powder convex structure section can be formed by introducing and storing the electromagnetic conductive or absorbing powder into the penetrating hole section of the member having a penetrating hole section.

Holding part

In the structure of the invention, an electromagnetic conducting or absorbing powder convex structure section is formed on the surface of the substrate, and a holding part is formed, at least partially (entirely or partially), on a portion of the substrate surface, where the electromagnetic conducting or absorbing powder convex structure section is not formed, in such a form capable of holding the convex structure of the electromagnetic conducting or absorbing powder convex structure section. It is thus important that the holding part is formed, at least partially, on a portion of the substrate surface, where the electromagnetic conducting or absorbing powder convex structure section is not formed, in such a form capable of holding the convex structure of the electromagnetic conducting or absorbing powder convex structure section. The holding part is preferably formed entirely on a portion of the substrate surface, where the electromagnetic conducting or absorbing powder convex structure section is not formed. Also the holding part may be formed on the substrate surface in any form, without any particular restriction, capable of fixing the holding part to the substrate surface in a state not easily peeled off, but is preferably formed in a state adhered to the substrate surface. For example, in the case that the substrate is a pressure-sensitive adhesive layer or an adhesive layer (a pressure-sensitive adhesive or adhesive layer) as described below, a holding part can be formed in a state adhered to the substrate surface, by adhering a member for forming a holding part (hereinafter also called "holding part-constituting member") onto the surface of the pressure-sensitive adhesive or adhesive layer employed as the substrate. Also in the case that the substrate is not a pressure-sensitive adhesive or adhesive layer, a holding part can be formed in a state adhered to the substrate surface, by utilizing already known fixing means (such as a method of adhesion to the substrate by a pressure-sensitive adhesive or an adhesive, or a method of forming a pressure-sensitive adhesive layer or an adhesive layer on a surface of the holding part-constituting member, and adhesion onto the substrate surface, utilizing the pressure-sensitive adhesive layer or the adhesive layer formed on a surface of the holding part-constituting member).

The holding part-constituting member is not particularly restricted so far as it is capable of holding the convex structure of the electromagnetic conducting or absorbing powder convex structure section. The holding part is preferably constituted of a member having at least a penetrating hole section or a concave section in a portion corresponding to the electromagnetic conducting or absorbing powder convex structure section formed on the substrate. The electromagnetic conducting or absorbing powder convex structure section can be easily formed on the substrate surface, by utilizing a member having a penetrating hole section or a member having a concave section, as the holding part-constituting member. Therefore, the structure of the invention preferably has a construction including a holding part formed by a member having a penetrating hole section or a member having a concave section, on the substrate surface, and a electromagnetic conducting or absorbing powder convex structure section on a portion of the substrate corresponding to the penetrating hole section or the concave section of the holding part.

The holding part formed by the member having the penetrating hole section or the member having the concave section may be constructed, according to the shape of the electromagnetic conducting or absorbing powder convex structure section to be formed on the substrate, by employing a single member having plural penetrating hole sections or plural concave sections, or by employing plural members having single or plural penetrating hole sections or single or plural concave sections.

In the member having a penetrating hole section or the member having a concave section, the shape of the penetrating hole section or the concave section is not particularly restricted as long as it is capable of positioning the electromagnetic conducting or absorbing powder convex structure section within the penetrating hole section or the concave section, but is preferably a shape corresponding to the shape of the electromagnetic conducting or absorbing powder convex structure section. More specifically, in the member having a penetrating hole section, the penetrating hole section may have, according to the shape of the electromagnetic conducting or absorbing powder convex structure section, any one of a fixed shape such as a substantially circular shape or a substantially polygonal shape, and various amorphous shapes. Also in the case that plural penetrating hole sections are provided, the arrangement of such plural penetrating hole sections may be either of a regularly arranged state and an irregularly arranged state.

Also in the member having a concave section, the concave section may have, according to the shape of the electromagnetic conducting or absorbing powder convex structure section, any one of a fixed shape such as a substantially circular shape or a substantially polygonal shape, and various amorphous shapes. Also in the case that plural concave sections are provided, the arrangement of such plural concave sections may be either of a regularly arranged state and an irregularly arranged state.

Therefore, in the member having a penetrating hole section or the member having a concave section, a diameter (such as average diameter, minimum diameter, maximum diameter or the like) of the penetrating hole section or the concave section, and a distance (such as average distance, minimum distance, maximum distance or the like) between the penetrating hole sections are not particularly restricted, and may be selected appropriated according for example to the shape of the electromagnetic conducting or absorbing powder convex structure section. Therefore, the penetrating hole sections or the concave sections may be formed regularly or irregularly.

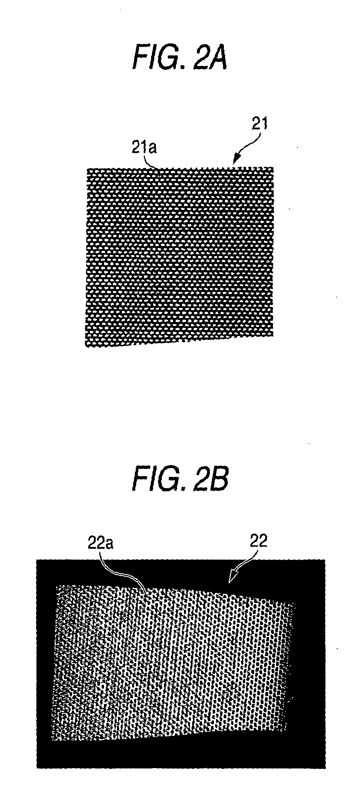

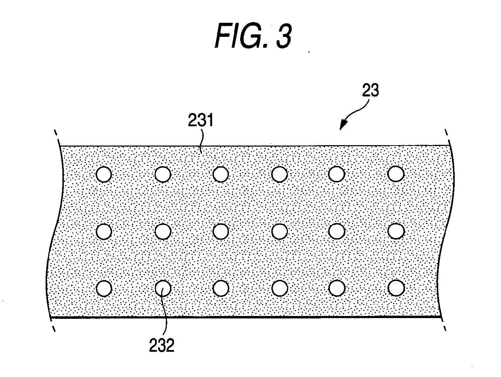

In the invention, the member having a penetrating hole section may be any member having a penetrating hole section without particular restriction, but advantageously employable is a member having plural penetrating hole sections in a net-like form as illustrated in Figs. 2A and 2B (also called "net-like member"), or a sheet-like member having plural penetrating hole sections formed by perforation as illustrated in Fig. 3 (also called "perforated sheet member"). Thus, the holding part-constituting member is preferably a net-like member or a perforated sheet member.

Figs. 2A and 2B are schematic partial views illustrating examples of the holding part-constituting member to be employed in the invention. Referring to Figs. 2A and 2B, there are illustrated net-like members 21, 22, a penetrating hole section 21a in the net-like member 21, and a penetrating hole section 22a in the net-like member 22. The net-like member 2 has a plurality of the penetrating hole sections 2a formed in a net-like form. In this manner, the net-like member can have a plurality of the penetrating hole sections of a fixed shape or an amorphous shape, formed either regularly or irregularly.

Fig. 3 is a schematic partial view illustrating an example of the holding part-constituting member to be employed in the structure of the invention. Referring to Fig. 3, there are illustrated a perforated sheet member 23, a sheet-like base material 231, and a penetrating hole section (perforated section) 232 formed by perforation. The perforated sheet member 23 has a plurality of perforated sections 232 as the penetrating hole sections, formed by a perforating work in prescribed portions of the sheet-like base material 231. In this manner, the perforated sheet member can have, as in the net-like member, a plurality of the penetrating hole sections of a fixed shape or an amorphous shape, formed either regularly or irregularly.

In particular, the perforated sheet member, being formed by a perforating work with a perforating machine, can easily control a shape, a size and a formed site of the penetrating hole sections (perforated sections) in the perforated sheet member. Thus the perforated sheet member has advantages of having a high freedom in designing the penetrating hole sections to be formed, and, in case of sticking or adhering to a substrate such as a pressure-sensitive adhesive or adhesive layer, of more easily securing an adhesion area than in a net-like member. In this manner, the perforated sheet member can be easily prepared in a form having the penetrating hole sections in a prescribed pattern shape, by regulating the size and the forming position of the penetrating hole sections at the perforating work.

Since such perforated sheet member is formed by a perforating work, a peripheral area around the formed perforated section generally has a thicker portion heaved in one surface side only, and the perforated sheet member is employed in such a form that the heaved thicker portion is positioned at the external side. In the invention, therefore, in the case that the member having a penetrating hole section is a perforated sheet member, a thickness of the thicker portion in the peripheral area around the perforated section (namely maximum thickness) is taken as the thickness of the perforated sheet member. On the other hand, in the case that the member having a penetrating hole section is a net-like member or a perforated sheet member not having a thicker portion in the peripheral area around the perforated section, a thickness in the peripheral area around the perforated section is taken as the thickness of the member having the penetrating hole section, but such thickness corresponds to an average thickness of the member having the penetrating hole section.

In the member having a penetrating hole section such as a net-like member or a perforated sheet member, a pore rate is not particularly limited, and may be appropriately selected according to the area of the electromagnetic conducting or absorbing powder convex structure section to be formed on the substrate, and is selectable for example within a range larger than 0% and equal to or smaller than 99.9%. The pore rate of the member having a penetrating hole section may be suitably selected for example according to the purpose of the structure or a size of the surface area on one surface of the structure. Specifically, in the case that the structure of the invention is utilized as an electromagnetic shield material for an electronic component (particularly an electronic component employed in so-called "mobile phone") or in the case that the structure has a limited surface area on one surface (for example a surface area of 500 mm$^2$ or less), the pore rate of the member having the penetrating hole section is preferably from 0.3 to 99.8%, more preferably from 30 to 90% and particularly preferably from 45 to 80%. Also in the case that the structure of the invention is utilized as an electromagnetic shield material for a building (for example use by adhesion to members constituting various surfaces (such as a wall surface, a ceiling surface, a floor surface and the like) of a building, by adhesion in advance to a construction material (such as boards or flooring materials) or in the case that the structure has a large surface area on one surface (for example a surface area of 0.5 m$^2$ or larger), the pore rate in the member having the penetrating hole section is preferably from 0.03 to 99.8%, more preferably from 0.1 to 50% and particularly preferably from 0.3 to 40%.

The pore rate in the member having the penetrating hole section is a value measured by the following "pore rate measuring method".

Pore rate measuring method

A member having a penetrating hole section, after being colored in an appropriate color if necessary, is placed on a paper showing a prescribed color different from that of the member having the penetrating hole section (for example by placing a member having a penetrating hole section, having a whitish color such as white color or milk-white color, on a black-colored paper, or by coloring a member having a penetrating hole section of any color into black color and by placing it on a white-colored paper), and is scanned by a scanner to fetch (input) image data of the member having the penetrating hole section into a computer. Then, on the computer, an image processing software "PHOTOSHOP ELEMENTS 2.0" (trade name of a digital image editing software, manufactured by Adobe Systems Inc.) is used to apply a processing or an editing such as removal of an unnecessary portion (specifically, for example in the case that the member having the penetrating hole section has a black color or is colored in black color, a processing or an editing is executed to convert unnecessary color portions into a prescribed color in such a manner that the portion of the member having the penetrating hole section constitutes a black-colored portion and the portion of the penetrating hole section constitutes a white-colored portion). After such processing or editing for obtaining two colors which are a color corresponding to the portion of the member having the penetrating hole section and a color corresponding to the portion of the penetrating hole section, an image processing software "MATROX INSPECTOR 2.1" (trade name of an image processing algorithm verifying tool, manufactured by Canon System Solutions Co.) is used to execute a binarization and to calculate a proportion or a ratio of each color per unit area (10 x 10mm) (by calculating a proportion or a ratio of each color in three different positions and determining an average value), thereby determining the ratio of the penetrating hole sections in the member having the penetrating hole section. More specifically, in the case that a member having a penetrating hole section, having black color or being colored in black color, is placed on a white-colored paper, proportions or ratios of white color and black color are determined, and, in such case, a ratio of black color (black ratio) becomes the ratio of the member having the penetrating hole section and a ratio of white color (white ratio) becomes the ratio of the penetrating hole sections in the member having the penetrating hole section (namely the pore rate of the member having the penetrating hole section).

In the image data of the member having the penetrating hole section, fetched into the computer by the scanner, in the case that a portion of the member having the penetrating hole section and a portion of the penetrating hole section are clearly distinguishable on a display image of the computer output even without a coloring of the member having the penetrating hole section, it is also possible, by an image processing software "PHOTOSHOP ELEMENTS 2.0" (trade name of a digital image editing software, manufactured by Adobe Systems Inc.), to apply a processing or an editing for separating the colors into the portion of the member having the penetrating hole section and the portion of the penetrating hole section, for obtaining two colors which are a color corresponding to the portion of the member having the penetrating hole section and a color corresponding to the portion of the penetrating hole section. Thereafter, in a similar manner as described above, an image processing software "MATROX INSPECTOR 2.1" (trade name of an image processing algorithm verifying tool, manufactured by Canon System Solutions Co.) is used to execute a binarization and to calculate a proportion or a ratio of each color per unit area (10 x 10 mm) (by calculating a proportion or a ratio of each color in three different positions and determining an average value), thereby determining the ratio of the penetrating hole sections in the member having the penetrating hole section.

Also the member having a concave section may be, without particular restriction, any member having a non-penetrating concave section (depressed section), and, specifically employable is a member having a concave section corresponding to the member having the penetrating hole section as illustrated in Figs. 2A, 2B and 3. In particular, when the concave section is formed by a perforating machine, a shape, a dimension and a forming site of the concave section can be easily controlled as in the case of the perforated sheet member.

In the member having a concave section, a content ratio of the concave section (namely a proportion of an area where the concave section is formed on the surface on which the concave section is formed) may be appropriately selected according to the area of the electromagnetic conducting or absorbing powder convex structure section formed on the substrate, as in the case of the member having the penetrating hole section, and is selectable for example within a range larger than 0% and equal to or smaller than 99.9%. The content ratio of the concave section can be determined by a method similar to the above-described method for measuring the pore rate in the member having the penetrating hole section.

A material for such holding part-constituting member is not particularly restricted, and examples thereof include a plastic material, a fibrous material, a paper material and a metal material. Examples of the plastic material include olefin-based resins such as polyethylene (low-density polyethylene, linear low-density polyethylene, medium-density polyethylene, or high-density polyethylene), polypropylene, poly-1-butene, poly-4-methyl-1-pentene, an ethylene-propylene copolymer, an ethylene-1-butene copolymer, an ethylene-vinyl acetate copolymer, an ethylene-acrylic acid ester type copolymer (such as an ethylene-ethyl acrylate copolymer or an ethylene-methyl methacrylate copolymer), and an ethylene-vinyl alcohol copolymer; polyester-based resins such as polyethylene terephthalate, polybutylene terephthalate, polyethylene naphthalate and polybutylene naphthalate; polyacrylate; styrene-based resins such as polystyrene, a styrene-isoprene copolymer, a styrene-butadiene copolymer, a styrene-isoprene-styrene copolymer, a styrene-butadiene-styrene copolymer and an acrylonitrile-butadiene-styrene copolymer; polyamide-based resins such as polyamide-6 and polyamide-6,6; polyvinyl chloride; polyvinylidene chloride; and polycarbonate.

Also examples of the fibrous material include a cotton fiber, a rayon fiber, a polyamide-based fiber, a polyester-based fiber, a polyacrylonitrile-based fiber, an acrylic fiber, a polyvinyl alcohol fiber, a polyethylene-based fiber, a polypropylene-based fiber, a polyimide-based fiber, a silicone-based fiber, and a fluorine-based resin fiber. Examples of the paper material include Japanese paper, machine-milled paper, wood-free paper, glassine paper, kraft paper, krupak paper, crepe paper, clay-coat paper, top-coat paper, synthetic paper, plastic-laminated paper, and plastic-coated paper. Examples of the metal material include an aluminum material and a copper material.

In the invention, a plastic material, a fibrous material or a paper material is preferred as the material for the holding part-constituting member, and a plastic material is particularly preferred. The material for the holding part-constituting member may be employed singly or in a combination of two or more kinds.

The holding part-constituting member is advantageously one that has a light weight and a satisfactory bending property. From the standpoint of light weight and bending property, a holding part-constituting member of a thin foil-like form (particularly a member of a sheet-like form) can be employed advantageously. Also the material for the holding part-constituting member is preferably a plastic material, among which particularly preferred is an olefin-based resin (particularly an ethylene-based resin and/or a propylene-based resin utilizing at least an ethylene monomer and/or a propylene monomer such as polyethylene, polypropylene and an ethylene-propylene copolymer), or a polyester-based resin (particularly polyethylene terephthalate).

A thickness (or height) of the holding part-constituting member is not particularly restricted but importantly is a thickness capable of holding the convex structure of the electromagnetic conducting or absorbing powder convex structure section. It can be suitably selected according to the thickness (or height) of the electromagnetic conducting or absorbing powder convex structure section, and is preferably similar to the thickness (or height) of the electromagnetic conducting or absorbing powder convex structure section, and can be selected for example from a range of from 95 to 105%, particularly selected as about 100% (for example from 99 to 100%) with respect to the thickness (or height) of the electromagnetic conducting or absorbing powder convex structure section.

The holding part-constituting member is not particularly restricted in the forming method thereof, and, in the case that the holding part-constituting member is for example a member having a penetrating hole section (particularly a net-like member or a perforated sheet member), it may be formed by a method of forming a penetrating hole section by a perforating work in a member not having a penetrating hole section thereby preparing a member having a penetrating hole section, or a method of a method of using a material for the member in such a state that a penetrating hole section can be formed, thereby preparing a member having a penetrating hole section. More specifically, for example in the case that the holding part-constituting member is a member having a penetrating hole section (particularly a net-like member or a perforated sheet member) and formed by a plastic material, a member formed by a plastic material and having a penetrating hole section (particularly a net-like member or a perforated sheet member) can be prepared by a method of forming a penetrating hole section in a prescribed site by a perforating work on a member not having a penetrating hole section, or a method of thermally fusing a plastic material to realize a state where a penetrating hole section can be formed, and executing a gravure printing (for example utilizing a roll having a convex portion or a concave portion).

The holding part-constituting member may be colored same as the color of the substrate, in consideration of the appearance of the structure. Also the holding part-constituting member may have electromagnetic conducting or absorbing properties for the purpose of improving the electromagnetic conducting or absorbing properties of the structure.

Substrate

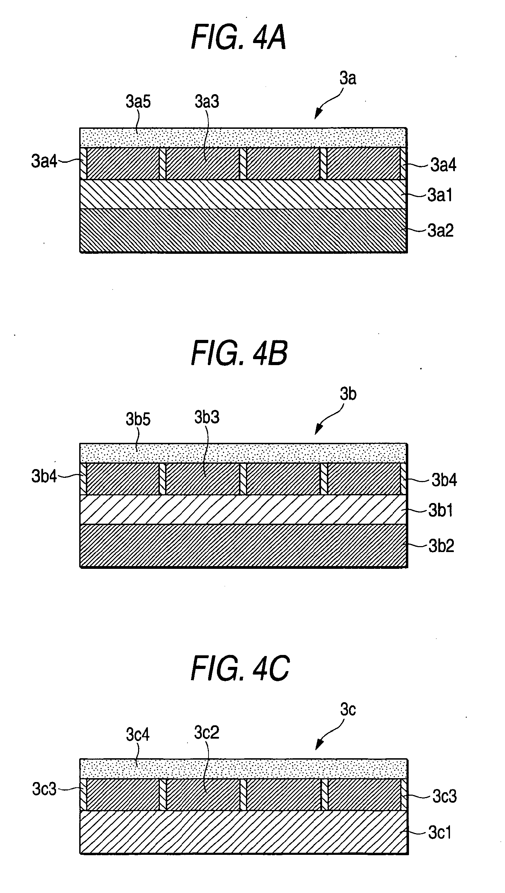

In such structure, the substrate for forming the electromagnetic conducting or absorbing powder convex structure section is not particularly restricted so far as it is capable of forming a electromagnetic conducting or absorbing powder convex structure section and a holding part. The substrate may have either of a single-layered form and a laminated form. In the invention, as the substrate, a pressure-sensitive adhesive layer, an adhesive layer or a polymer layer may be employed advantageously, as illustrated in Figs. 4A to 4C, and a pressure-sensitive adhesive layer or an adhesive layer (also called "pressure-sensitive adhesive or adhesive layer") is advantageous. Figs. 4A to 4C are schematic cross-sectional views illustrating examples of the structure of the invention, wherein illustrated are a structure 3a, a pressure-sensitive adhesive or adhesive layer (pressure-sensitive adhesive layer or adhesive layer) 3a1, a base material 3a2, an electromagnetic conducting or absorbing powder convex structure section 3a3, a holding part 3a4, a coating layer 3a5, a structure 3b, a pressure-sensitive adhesive layer 3ba, a release liner 3b2, an electromagnetic conducting or absorbing powder convex structure section 3b3, a holding part 3b4, a coating layer 3b5, a structure 3c, a polymer layer 3c1, a electromagnetic conducting or absorbing powder convex structure section 3c2, a holding part 3c3, and a coating layer 3c4. The structure 3a illustrated in Fig. 4A has a construction that a pressure-sensitive adhesive or adhesive layer 3a1 is formed as a substrate partially on a surface of the base material 3a2 as a support, an electromagnetic conducting or absorbing powder convex structure section 3a3 is formed partially on the pressure-sensitive adhesive or adhesive layer 3a1, and, on a site (or portion) of the surface of the pressure-sensitive adhesive or adhesive layer 3a1 where the electromagnetic conducting or absorbing powder convex structure section is not formed, the holding part 3a4 is formed in such a form as to hold the convex structure of the electromagnetic conducting or absorbing powder convex structure section. The structure 3b illustrated in Fig. 4B has a construction that a pressure-sensitive adhesive layer 3b1 is formed as a substrate on a surface of the release liner 3b2 as a support, an electromagnetic conducting or absorbing powder convex structure section 3b3 is formed partially on the surface of such pressure-sensitive adhesive layer 3b1, and, on a site of the surface of the pressure-sensitive adhesive or adhesive layer 3b1 where the electromagnetic conducting or absorbing powder convex structure section is not formed, the holding part 3b4 is formed in such a form as to hold the convex structure of the electromagnetic conducting or absorbing powder convex structure section. The structure 3c illustrated in Fig. 4C has a construction that an electromagnetic conducting or absorbing powder convex structure section 3c2 is formed partially on the surface of the polymer layer 3c1 as the substrate, and, on a site of the surface of the polymer layer 3c1 where the electromagnetic conducting or absorbing powder convex structure section is not formed, the holding part 3c3 is formed in such a form as to hold the convex structure of the electromagnetic conducting or absorbing powder convex structure section.

In such pressure-sensitive adhesive or adhesive layer (pressure-sensitive adhesive or adhesive layer) as the substrate, the pressure-sensitive adhesive which constitutes the pressure-sensitive adhesive layer is not particularly limited, and examples thereof include known pressure-sensitive adhesives such as a rubber-based pressure-sensitive adhesive, an acrylic pressure-sensitive adhesive, a polyester-based pressure-sensitive adhesive, an urethane-based pressure-sensitive adhesive, a polyamide-based pressure-sensitive adhesive, an epoxy-based pressure-sensitive adhesive, a vinyl alkyl ether-based pressure-sensitive adhesive, a silicone-based pressure-sensitive adhesive, and a fluorine-based pressure-sensitive adhesive. Furthermore, the pressure-sensitive adhesive may be a hot melt type pressure-sensitive adhesive. On the other hand, the adhesive which constitutes the adhesive layer is not particularly limited, and examples thereof include known adhesives such as a rubber-based adhesive, an acrylic adhesive, a polyester-based adhesive, an urethane-based adhesive, a polyamide-based adhesive, an epoxy-based adhesive, a vinyl alkyl ether-based adhesive, a silicone-based adhesive, and a fluorine-based adhesive. Moreover, the adhesive may be a heat-sensitive adhesive. The pressure-sensitive adhesive or adhesive can be used singly or in a combination of two or more kinds thereof. The pressure-sensitive adhesive or adhesive may be a pressure-sensitive adhesive or adhesive of any form such as an emulsion type form, a solvent type form, an oligomer type form, and a solid type form.

Incidentally, the pressure-sensitive adhesive or adhesive may contain, in addition to a polymer component (base polymer) such as a pressure-sensitive adhesive component or an adhesive component, appropriate additives such as a crosslinking agent (for example, a polyisocyanate-based crosslinking agent and an alkyl etherified melamine compound-based crosslinking agent), a tackifier (for example, a rosin derivative resin, a polyterpene resin, a petroleum resin, and a phenol resin), a plasticizer, a filler, and an antiaging agent depending upon the type of the pressure-sensitive adhesive or adhesive and the like. In the case of performing crosslinking in forming the pressure-sensitive adhesive layer or adhesive layer, a known crosslinking method such as a heat crosslinking method by heating, an ultraviolet ray crosslinking method by irradiation with ultraviolet rays (UV crosslinking method), an electron beam crosslinking method by irradiation with electron beams (EB crosslinking method), and a spontaneous curing method for achieving spontaneous curing at the room temperature, and the like can be applied.

In the invention, a pressure-sensitive adhesive layer is suitable as the pressure-sensitive adhesive or adhesive layer. As the pressure-sensitive adhesive which constitutes the pressure-sensitive adhesive layer, a rubber-based pressure-sensitive adhesive or an acrylic pressure-sensitive adhesive can be used advantageously.

As a method of forming the pressure-sensitive adhesive or adhesive layer, a known method for forming a pressure-sensitive adhesive layer or a known method for forming an adhesive layer (for example, a coating method or a transfer method) can be employed. The forming method can be properly selected depending upon the type, shape and size of the support for forming the structure or the pressure-sensitive adhesive or adhesive layer. For example in the case where the pressure-sensitive adhesive layer is formed on the substrate as a support, examples of the method for forming the pressure-sensitive adhesive layer include a method of coating a pressure-sensitive adhesive on the substrate (coating method); and a method of coating a pressure-sensitive adhesive on a release film such as a release liner to form a pressure-sensitive adhesive layer and then transferring this pressure-sensitive adhesive layer onto the substrate (transfer method). Also in the case where the pressure-sensitive adhesive layer is formed on a release liner as described in the following, examples of the method for forming the pressure-sensitive adhesive layer include a method of coating a pressure-sensitive adhesive on the releasing surface of the release liner (coating method). Also examples of the method for forming an adhesive layer include, in the case that the adhesive layer is formed on a substrate as a support, a method of coating an adhesive on a prescribed surface of the substrate (coating method).

On the other hand, a polymer component for constructing the polymer layer as the substrate is not particularly limited, and one or two or more kinds of known polymer components (for example, a resin component such as a thermoplastic resin, a thermosetting resin or an ultraviolet ray-curable resin, a rubber component, and an elastomer component) can be properly selected and used. Concretely, in the polymer component which constructs the polymer layer, examples of the resin component include an acrylic resin, a styrene-based resin, a polyester-based resin, a polyolefin-based resin, polyvinyl chloride, a vinyl acetate-based resin, a polyamide-based resin, a polyimide-based resin, a urethane-based resin, an epoxy-based resin, a fluorine-based resin, a silicone-based resin, polyvinyl alcohol, polycarbonate, polyacetal, polyetherimide, polyamide-imide, polyesterimide, polyphenylene ether, polyphenylene sulfide, polyethersulfone, polyetheretherketone, polyetherketone, polyallylate, polyaryl, and polysulfone. Furthermore, examples of the rubber component include natural rubber and synthetic rubber (for example, polyisobutylene, polyisoprene, chloroprene rubber, butyl rubber, and nitrile butyl rubber). Moreover, examples of the elastomer component include a variety of thermoplastic elastomers such as an olefin-based thermoplastic elastomer, a styrene-based thermoplastic elastomer, a polyester-based thermoplastic elastomer, a polyamide-based thermoplastic elastomer, a polyurethane-based thermoplastic elastomer, and an acrylic thermoplastic elastomer.

The thickness of the substrate (pressure-sensitive adhesive or polymer layer) is not particularly limited, and it may be selected within a range of from about 1 to 1,000 $\mu$m (preferably from 10 to 500 $\mu$m).

In the invention, it is preferable that the substrate (such as pressure-sensitive adhesive or adhesive layer or polymer layer) has electromagnetic conducting or absorbing properties from the viewpoint of further improving the electromagnetic conducting or absorbing properties of the structure. The substrate having electromagnetic conducting or absorbing properties can be formed from a composition containing an electromagnetic conducting or absorbing material (for example, a pressure-sensitive adhesive composition, an adhesive composition, or a polymer composition). The electromagnetic conducting or absorbing material which is used in the substrate is not particularly limited. For example, one or two or more kinds of an electromagnetic conducting or absorbing material such as a metal material, an electromagnetic conducting or absorbing plastic material (such as an electrically conductive plastic material), and a magnetic material may be employed. Incidentally, examples of the metal material, the electromagnetic conducting or absorbing material and the magnetic material include the above-enumerated metal material, electromagnetic conducting or absorbing material and magnetic material (for example, a metal material, an electromagnetic conducting or absorbing plastic material, and a magnetic material as enumerated in the electromagnetic conducting or absorbing powder for constructing the electromagnetic conducting or absorbing powder convex structure section). The electromagnetic conducting or absorbing material such as a metal material, an electromagnetic conducting or absorbing plastic material or a magnetic material may have any form such as a powder form, a film form, a foil form, a thin layer form, and a fibrous form.

The substrate containing the electromagnetic conducting or absorbing material (such as a pressure-sensitive adhesive composition, an adhesive composition or a polymer composition) can be prepared by mixing a pressure-sensitive adhesive for forming a pressure-sensitive adhesive layer, an adhesive for forming an adhesive layer or a polymer component for forming a polymer layer, and an electromagnetic conducting or absorbing material. The content proportion of the electromagnetic conducting or absorbing material is not particularly limited and can be properly selected depending upon the pressure-sensitive adhesivity or adhesivity of the pressure-sensitive adhesive or adhesive, and the electromagnetic conducting or absorbing property of the pressure-sensitive adhesive or adhesive layer or the polymer layer, and it is preferably from 3 to 98% by weight (in particular, from 5 to 95% by weight) with respect to the total amount of solids in the pressure-sensitive adhesive composition, adhesive composition or polymer composition. An excessively low content proportion of the electromagnetic conducting or absorbing material reduces the electromagnetic conducting or absorbing properties of the substrate, while an excessively high content proportion reduces the pressure-sensitive adhesive or adhesive property, when the substrate is a pressure-sensitive adhesive or adhesive layer.

Support

In the structure of the invention, the substrate (particularly a pressure-sensitive adhesive or adhesive layer as the substrate) may be formed on at least one surface of a support. In the case that the substrate is formed on both surfaces of the support, the electromagnetic conducting or absorbing powder convex structure section and the holding part may be formed on only the substrate formed on one surface of the support, or the electromagnetic conducting or absorbing powder convex structure section and the holding part may be formed on the substrates formed on both surfaces of the support.

Such support is not particularly limited and may be suitably selected for example according to the type of the structure. The support may have any form, and examples thereof include spherical, cylindrical, polygonal, polygonal conical, conical, tabular, and sheet-like forms. Also the material of the support is not particularly restricted, and may be any material such as a plastic material, a metal material, a fibrous material or a paper material, and such materials may be used singly or in a combination of two or more types.

In the present invention, the support preferably has a sheet-like form. In the case that the support has a sheet-like form, the structure can be utilized as a sheet-like structure having a sheet-like form. Examples of the support having such sheet-like form include, in the case that the substrate is a pressure-sensitive adhesive or adhesive layer, a sheet-like base material such as a base material for a pressure-sensitive adhesive tape or sheet, and a release liner for a pressure-sensitive adhesive tape or sheet. More specifically, in the case that the structure is formed as a pressure-sensitive adhesive tape or sheet of a base material-including type having the pressure-sensitive adhesive layer on one side or on both sides, a base material for the pressure-sensitive adhesive tape or sheet may be used as the support. Also in the case that the structure is formed as a double-sided pressure-sensitive adhesive tape or sheet of a base material-less type, a release liner (separator) for the pressure-sensitive adhesive tape or sheet may be used as the support. In the case that the structure is formed as a pressure-sensitive adhesive tape or sheet of a base material-including type having the pressure-sensitive adhesive layer on one side or on both sides, the structure may have a construction in which the pressure-sensitive adhesive layer is formed on one surface or both surfaces of a base material (base material for pressure-sensitive adhesive tape or sheet) as the support, and the electromagnetic conducting or absorbing powder convex structure section and the holding part are formed on a surface of the pressure-sensitive adhesive layer, formed on one or both surfaces of the base material. On the other hand, in the case that the structure is formed as a double-sided pressure-sensitive adhesive tape or sheet of a base material-less type, the structure may have a construction in which a release liner (release liner for pressure-sensitive adhesive tape or sheet) is used as the support for the pressure-sensitive adhesive layer and the electromagnetic conducting or absorbing powder convex structure section and the holding part are formed on a surface of the pressure-sensitive adhesive layer. The release liner as the support supports the pressure-sensitive adhesive layer until the structure is used and protects the surface of the pressure-sensitive adhesive layer.

Base material

As the base material serving as a support, a sheet-like base material can be employed advantageously, as described above. For such sheet-like base material, a base material for a pressure-sensitive adhesive tape or sheet (base material) can be used advantageously. As the base material, an appropriate thin sheet member for example a plastic base material such as a plastic film or sheet; a metallic base material such as a metal foil or a metal plate; a paper-based base material for example paper (such as wood-free paper, Japanese paper, kraft paper, glassine paper, synthetic paper, and topcoat paper); a fibrous base material such as a cloth, a non-woven cloth, or a net; a rubber-based base material such as a rubber sheet; and a foamed member such as a foamed sheet, can be used. The base material may have a single-layered form or a laminated form. For example, the base material may be a multilayered member (two- or three-layered composite member) of a plastic base material and another base material (such as a metallic base material, a paper-based base material, or a fibrous base material) formed by lamination, co-extrusion, or the like. A foamed member employed as the substrate allows to improve the adaptability to the surface irregularities of an adhered member.

The base material is preferably a plastic base material such as a plastic film or sheet. Examples of a raw material (plastic material) for such plastic base material include an olefin-based resin composed of an a-olefin as a monomer component, such as polyethylene (PE), polypropylene (PP), an ethylene-propylene copolymer, or an ethylene-vinyl acetate copolymer (EVA); a polyester-based resin such as polyethylene terephthalate (PET), polyethylene naphthalate (PEN), or polybutylene terephthalate (PBT); polyvinyl chloride (PVC); a vinyl acetate-based resin; polyphenylene sulfide (PPS); an amide-based resin such as a polyamide (nylon) or a wholly aromatic polyamide (aramid); a polyimide-based resin; and polyetheretherketone (PEEK). Furthermore, in the base material, the plastic material of the plastic base material may be an electromagnetic conducting or absorbing plastic material (for example an electrically conductive plastic material). Examples of the electrically conductive plastic material include an electrically conductive polymer as enumerated previously in the electromagnetic conductive or absorbing fiber. The plastic material may be used singly or in a mixed state of a combination of two or more kinds. Incidentally, the plastic film or sheet may be of a non-stretched type or a stretched type having been subjected to a uniaxial or biaxial stretching treatment.

Furthermore, examples of the metal material for forming the metallic base material (for example, a metal foil and a metal plate) include metal materials as enumerated previously in the electromagnetic conducting or absorbing powder. The metal material can be used singly or in a combination of two or more kinds thereof.

In the invention, for the purpose of further enhancing the electromagnetic conducting or absorbing properties of the structure, a base material having electromagnetic conducting or absorbing properties (also called "electromagnetic conducting or absorbing base material") can be used advantageously as the base material. The electromagnetic conducting or absorbing base material is not particularly restricted so far as it can exhibit electromagnetic conducting or absorbing properties, and examples thereof include a base material constituted of a electromagnetic conducting or absorbing material and a base material containing a electromagnetic conducting or absorbing material on a surface or in the interior.

In the electromagnetic conducting or absorbing base material, the base material constituted of an electromagnetic conducting or absorbing material is not particularly limited. For example, an electromagnetic conducting or absorbing material such as a metal material, an electromagnetic conducting or absorbing plastic material (for example, an electrically conductive plastic material), and a magnetic material can be used singly or in a combination of two or more kinds. Incidentally, examples of the metal material, the electromagnetic conducting or absorbing plastic material, and the magnetic material include an electromagnetic conducting or absorbing powder which constructs the electromagnetic conducting or absorbing powder convex structure section, and a metal material, an electromagnetic conducting or absorbing plastic material, and a magnetic material as enumerated in the electromagnetic conducting or absorbing material to be contained in the pressure-sensitive adhesive composition or adhesive composition.

Furthermore, the base material containing an electromagnetic conducting or absorbing material on the surface or inside thereof is not particularly limited so far as it is a base material of any kind in which an electromagnetic conducting or absorbing material is used on the surface or inside thereof. Examples of the base material containing an electromagnetic conducting or absorbing material on the surface thereof include a base material having a layer made of an electromagnetic conducting or absorbing material-containing composition containing an electromagnetic conducting or absorbing material (hereinafter also called "electromagnetic conducting or absorbing material-containing layer") on the surface thereof. In the base material having an electromagnetic conducting or absorbing material-containing layer on the surface thereof, it is only required that the electromagnetic conducting or absorbing material-containing layer is formed on at least one surface of the base material. Furthermore, the thickness of the electromagnetic conducting or absorbing material-containing layer is not particularly limited. For example, it can be properly selected within the range of 0.1 $\mu$m or more (for example, from 0.1 1 $\mu$M to 1 mm) and the electromagnetic conducting or absorbing material-containing layer may be a thin layer (for example, a thin film layer having a thickness of from about 0.1 to 30 $\mu$m). Accordingly, the base material having an electromagnetic conducting or absorbing material-containing layer on the surface thereof may be a base material having a construction in which an electromagnetic conducting or absorbing material-containing layer having a thin thickness is formed on a base material not having the electromagnetic conducting or absorbing properties (hereinafter also called "non-electromagnetic conducting or absorbing base material") or may be a base material having a construction in which a non-electromagnetic conducting or absorbing base material and an electromagnetic conducting or absorbing material-containing layer are laminated.

In an electromagnetic conducting or absorbing material-containing composition for forming such an electromagnetic conducting or absorbing material-containing layer, the electromagnetic conducting or absorbing material may be contained as a principal component or a mixing component (sub-component). The electromagnetic conducting or absorbing material is not particularly limited and examples thereof include a metal material, an electromagnetic conducting or absorbing plastic material (for example, an electrically conducting plastic material), and a magnetic material. Accordingly, the electromagnetic conducting or absorbing material-containing layer may be a metal material layer such as a metal foil or a metal plate, an electromagnetic conducting or absorbing plastic material layer such as an electromagnetic conducting or absorbing plastic material-made film or sheet, or a magnetic material layer. Incidentally, examples of the metal material for forming the electromagnetic conducting or absorbing material-containing layer include a metal material as enumerated previously in the electromagnetic conducting or absorbing powder which constructs the electromagnetic conducting or absorbing powder convex structure section. Furthermore, examples of the electromagnetic conducting or absorbing plastic material include an electromagnetic conducting or absorbing plastic material as enumerated previously in the electromagnetic conducting or absorbing powder which constructs the electromagnetic conducting or absorbing powder convex structure section. Moreover, examples of the magnetic material include a magnetic material as enumerated previously in the electromagnetic conducting or absorbing powder which constructs the electromagnetic conducting or absorbing powder convex structure section. The electromagnetic conducting or absorbing material can be used singly or in a combination of two or more kinds thereof. Incidentally, the electromagnetic conducting or absorbing material such as a metal material, an electromagnetic conducting or absorbing plastic material, or a magnetic may have any form such as a powder form, a film-like form, a foil-like form, or a thin layer-like form.

Furthermore, the non-electromagnetic conducting or absorbing base material to be coated or laminated by the electromagnetic conducting or absorbing material is not particularly limited so far as it is a base material not having electromagnetic conducting or absorbing properties. Examples thereof include a plastic base material not having electromagnetic conducting or absorbing properties (for example, a plastic base material constituted of, as a raw material, a resin not having electromagnetic conducting or absorbing properties such as a polyolefin-based resin, a polyester-based resin, polyvinyl chloride, a vinyl acetate-based resin, polyphenylene sulfide, an amide-based resin, a polyimide-based resin, and polyetheretherketone); a paper-based base material not having electromagnetic conducting or absorbing properties (such as wood-free paper, Japanese paper, kraft paper, glassine paper, synthetic paper, or topcoat paper); and a fibrous base material not having electromagnetic conducting or absorbing properties (such as a cloth or non-woven cloth not having electromagnetic conducting or absorbing properties). Incidentally, the non-electromagnetic conducting or absorbing base material may have a single-layered form or a laminated form.

Incidentally, in the base material having an electromagnetic conducting or absorbing material-containing layer on the surface thereof, a method for forming an electromagnetic conducting or absorbing material-containing material on the surface of the base material is not particularly limited and can be properly selected and applied from a known method (for example, a metal vapor deposition method, a metal plating method, a lamination method by adhesion, an impregnation method, and a coating method) depending upon the type of the electromagnetic conducting or absorbing material, the thickness of the electromagnetic conducting or absorbing material-containing layer, and the like. For example, in the case where the electromagnetic conducting or absorbing material is a metal material and the electromagnetic conducting or absorbing material-containing layer is an electromagnetic conducting or absorbing material-containing layer having a thin thickness, the electromagnetic conducting or absorbing material-containing layer can be formed on the surface of the base material by applying a coating method by vapor deposition of a metal material, a coating method by plating of a metal material, and the like. Accordingly, the base material having an electromagnetic conducting or absorbing material-containing layer on the surface thereof may be a plastic film or sheet having a metal material vapor-deposited on the surface thereof (a metal vapor-deposited plastic film or sheet) or a plastic film or sheet having a metal material plated on the surface thereof (a metal plated plastic film or sheet).

On the other hand, examples of the base material containing an electromagnetic conducting or absorbing material in the inside thereof include a base material which is formed of an electromagnetic conducting or absorbing material-containing composition containing an electromagnetic conducting or absorbing material. Such a base material may be a base material in which an electromagnetic conducting or absorbing material is formed as a principal material which constructs the base material (hereinafter also called "electromagnetic conductive or absorbing material-based base material") or a base material formed of a mixed material containing a principal material which constructs the base material and an electromagnetic conducting or absorbing material (hereinafter also called "electromagnetic conducting or absorbing material-containing base material"). Examples of the electromagnetic conducting or absorbing material-based base material include a metallic base material such as a metal foil or a metal plate; an electromagnetic conducting or absorbing plastic base material such as a film or sheet formed of an electromagnetic conducting or absorbing plastic material; a fibrous base material having electromagnetic conducting or absorbing properties (electromagnetic conducting or absorbing fibrous base material) for example a woven fabric (such as a cloth) or non-woven fabric formed of a fiber having electromagnetic conducting or absorbing properties; and a magnetic material-based base material such as a magnetic material plate. Examples of a metal material for forming the metallic base material include a metal material as enumerated previously in the electromagnetic conducting or absorbing powder which constructs the electromagnetic conducting or absorbing powder convex structure section. Furthermore, examples of an electromagnetic conducting or absorbing plastic material for forming the electromagnetic conducting or absorbing plastic base material include an electromagnetic conducting or absorbing plastic material as enumerated previously in the electromagnetic conducting or absorbing powder which constructs the electromagnetic conducting or absorbing powder convex structure section. Moreover, examples of a fiber in the electromagnetic conducting or absorbing fibrous base material include a fiber formed by using an electromagnetic conducting or absorbing powder (such as a carbon-based fiber, a fiber made of an electrically conductive polymer, or a metallic fiber) as enumerated previously in the electromagnetic conducting or absorbing fiber which constructs the electromagnetic conducting or absorbing fiber convex structure section. In addition, examples of a magnetic material in the magnetic material-based base material include a magnetic material as enumerated previously in the electromagnetic conducting or absorbing powder which constructs the electromagnetic conducting or absorbing powder convex structure section.

Furthermore, in the electromagnetic conducting or absorbing material-containing base material, examples of the principal material which constitutes the base material include a material not having electromagnetic conducting or absorbing properties (hereinafter also called "non-electromagnetic conducting or absorbing material"), for example a plastic material not having electromagnetic conducting or absorbing properties (for example a resin not having electromagnetic conducting or absorbing properties such as a polyolefin-based resin, a polyester-based resin, polyvinyl chloride, a vinyl acetate-based resin, polyphenylene sulfide, an amide-based resin, a polyimide-based resin, or polyetheretherketone); a paper material not having electromagnetic conducting or absorbing properties (for example a paper material capable of forming a paper-based base material not having electromagnetic conducting or absorbing properties such as wood-free paper, Japanese paper, kraft paper, glassine paper, synthetic paper, or topcoat paper); and a fiber material not having electromagnetic conducting or absorbing properties (for example a fiber material capable of forming a fibrous base material not having electromagnetic conducting or absorbing properties such as a cloth or a non-woven cloth not having electromagnetic conducting or absorbing properties). The non-electromagnetic conducting or absorbing material may be used singly or in a combination of two or more kinds. Examples of the electromagnetic conducting or absorbing material in the electromagnetic conducting or absorbing material-containing base material include a metal material as enumerated previously in the electromagnetic conducting or absorbing powder which constructs the electromagnetic conducting or absorbing powder convex structure section, an electromagnetic conducting or absorbing plastic material as enumerated previously in the electromagnetic conducting or absorbing powder which constructs the electromagnetic conducting or absorbing powder convex structure section, and a magnetic material as enumerated previously in the electromagnetic conducting or absorbing powder which constructs the electromagnetic conducting or absorbing powder convex structure section.

Incidentally, in the electromagnetic conducting or absorbing material-containing base material, in the case where the principal material which constitutes the base material is a fiber material not having electromagnetic conducting or absorbing properties, the electromagnetic conducting or absorbing material may be contained in a form impregnated in the fiber or in a form mixed in the fiber material constituting the fiber.

In the base material containing an electromagnetic conducting or absorbing material in the inside thereof, a method for containing the electromagnetic conducting or absorbing material in the inside of the base material is not particularly limited. For example, in the case where the base material containing an electromagnetic conducting or absorbing material in the inside thereof is an electromagnetic conducting or absorbing material-based base material, it is possible to form the electromagnetic conducting or absorbing material-based base material by applying a known method for forming a metal foil, a known method for forming a plastic film or sheet, a known method forming a fiber, or the like depending upon the type of the electromagnetic conducting or absorbing material-based base material, etc. Furthermore, in the case where the base material containing an electromagnetic conducting or absorbing material in the inside thereof is an electromagnetic conducting or absorbing material-containing base material, for example, after mixing the principal material constituting the base material with the electromagnetic conducting or absorbing material, the electromagnetic conducting or absorbing material-containing base material can be formed by applying a known method for forming a metal foil, a known method for forming a plastic film or sheet, or the like depending upon the types of the principal material constituting the base material and the electromagnetic conducting or absorbing material.

Incidentally, if desired, the electromagnetic conducting or absorbing base material may contain a variety of additives such as an inorganic filler (such as titanium oxide or zinc oxide), an antiaging agent (such as an amine-based antiaging agent, a quinoline-based antiaging agent, a hydroquinone-based antiaging agent, a phenol-based antiaging agent, a phosphorus-based antiaging agent, or a phosphorous acid ester-based antiaging agent), an antioxidant, an ultraviolet absorber (such as a salicylic acid derivative, a benzophenone-based ultraviolet absorber, a benzotriazole-based ultraviolet absorber, or a hindered amine-based ultraviolet absorber), a lubricant, a plasticizer, and a coloring agent (such as a pigment or a dye). Also an electromagnetic conducting or absorbing material may be blended in the base material as described before.

For the purpose of improving adhesion to the pressure-sensitive adhesive or adhesive layer or the like, one or both surfaces of the electromagnetic conducting or absorbing base material may be subjected to an appropriate surface treatment for example a physical treatment such as a corona treatment or a plasma treatment or a chemical treatment such as an undercoating treatment.

The thickness of the electromagnetic conducting or absorbing base material is not particularly limited. For example, it may be selected within a range of from about 10 $\mu$m to 20 mm, and preferably from about 30 $\mu$m to 12 mm.

Release liner

Examples of the release liner as a support (such as a release liner for pressure-sensitive adhesive tape or sheet) include a base material having a release treated layer formed by a release agent on at least one surface, and a known base material having a low adhesivity. As the release liner, a release liner formed by a base material for release liner and having a release treated layer on at least one surface thereof is suitable. Examples of the base material for release liner include a plastic base material film (synthetic resin film) of every kind, paper, and a multilayered member (two- or three-layered composite member) formed by laminating or co-extruding these base materials. For example, the release treated layer can be formed by using a known release treating agent such as a silicone-based release treating agent, a fluorine-based release treating agent, or a long-chain alkyl-based release treating agent, either singly or in a combination of two or more kinds. The release treated layer can be formed by coating a release treating agent on a prescribed surface (at least one surface) of a base material for release liner, followed by a heating step for drying or a curing reaction.

The thickness of the release liner, the thickness of the base material for release liner, and the thickness of the release treated layer are not particularly limited and can be properly selected depending for example upon the shape of the electromagnetic conducting or absorbing powder convex structure section.

Coating layer

In the invention, in the case that the holding part is formed by a member having a penetrating hole section, it is important, in order to hold the electromagnetic conductive or absorbing powder introduced into the penetrating hole section in the member having the penetrating hole section, that a coating layer is formed as illustrated in Figs. 1 and Figs. 4A to 4C so as to cover the surface on which the electromagnetic conducting or absorbing powder convex structure section is exposed. Since such coating layer is a layer that covers the surface at the side where the electromagnetic conducting or absorbing powder convex structure section is exposed, the electromagnetic conducting or absorbing powder convex structure section has a construction that the electromagnetic conductive or absorbing powder is contained in the interior of the space which is formed by the substrate, the holding part formed by the member having the penetrating hole section, and the coating layer (namely in the interior of the penetrating hole section in the member having the penetrating hole section).

The coating layer may be formed in a form not in contact with the electromagnetic conducting or absorbing powder convex structure section, but is ordinarily formed in a form in contact with the electromagnetic conducting or absorbing powder convex structure section as illustrated in Fig. 1 and in Figs. 4A to 4C.

The coating material constituting the coating layer is not particularly limited and examples thereof include a coating material composition containing, as a principal component, a known polymer component (for example a resin component such as a thermoplastic resin, a thermosetting resin, or an ultraviolet ray-curable resin, a rubber component, or an elastomer component). Concretely, in the coating material composition constituting the coating layer, the polymer component can be properly selected and used among polymer components same as the polymer components as enumerated previously for the substrate (for example a resin component such as a thermoplastic resin, a thermosetting resin, or an ultraviolet ray-curable resin, a rubber component, and an elastomer component).

The coating layer may have a single-layered form or a laminated formed.

In the invention, it is preferable that the coating layer has electromagnetic conducting or absorbing properties. When also the coating layer has the electromagnetic conducting or absorbing properties, it is possible to further enhance the electromagnetic conducting or absorbing properties of the structure. The coating layer having the electromagnetic conducting or absorbing properties can be formed by a coating material composition containing an electromagnetic conducting or absorbing material. The electromagnetic conducting or absorbing material which is used in the coating material is not particularly limited. For example, an electromagnetic conducting or absorbing material such as a metal material, an electromagnetic conducting or absorbing plastic material (for example, an electrically conductive plastic material), and a magnetic material can be used singly or in a combination of two or more kinds. Incidentally, examples of the metal material, the electromagnetic conducting or absorbing plastic material, and the magnetic material include a metal material, an electromagnetic conducting or absorbing plastic material, and a magnetic material as enumerated previously (for example, a metal material, an electromagnetic conducting or absorbing plastic material, and a magnetic material as enumerated previously in the electromagnetic conducting or absorbing powder which constructs the electromagnetic conducting or absorbing powder convex structure section, the pressure-sensitive adhesive composition or adhesive composition which constructs the pressure-sensitive adhesive or adhesive layer, and the composition which constructs the substrate).

The coating material composition containing an electromagnetic conducting or absorbing material can be prepared by mixing a coating material and an electromagnetic conducting or absorbing material. Incidentally, in the coating material composition, the content proportion of the electromagnetic conducting or absorbing material is not particularly limited but can be properly selected depending upon the type of a polymer component of the coating material, and the electromagnetic conducting or absorbing properties of the coating layer. For example, the content proportion of the electromagnetic conducting or absorbing material is preferably from 3 to 98% by weight (in particular, from 5 to 95% by weight) with respect to the total solids in the coating material composition. An excessively low content proportion of the electromagnetic conducting or absorbing material reduces the electromagnetic conducting or absorbing properties of the coating layer, while an excessively high content proportion renders the formation of the coating layer difficult.

Since the coating layer is a layer for covering the electromagnetic conducting or absorbing powder convex structure section and the holding part, it is important that, in forming the coating layer, the electromagnetic conducting or absorbing powder convex structure section and the holding part are formed in advance on the substrate. However, it is also possible, before forming the electromagnetic conducting or absorbing powder convex structure section, to form the coating layer on a surface of the member having the penetrating hole section as the holding part-constituting member. More specifically, the structure of the invention can also be produced for example by forming a coating layer on a surface of a member having a penetrating hole section as the holding part-constituting member, then introducing a electromagnetic conductive or absorbing powder for constructing the electromagnetic conducting or absorbing powder convex structure section into the penetrating hole section in the member having the penetrating hole section, and adhering a substrate on a surface on which the electromagnetic conducting or absorbing powder convex structure section is exposed.

As a method for forming the coating layer, a known forming method (for example, a coating method, a dip method, or a spray method) can be employed. The forming method can be properly selected depending upon the form of the coating layer, the type and form of the electromagnetic conducting or absorbing powder convex structure section. More specifically, the coating layer can be formed by coating a coating material composition on the surface on which the electromagnetic conducting or absorbing powder convex structure section is exposed.

The thickness of the coating layer is not particularly limited and can be properly selected depending upon the type and form of the coating layer, the thickness (height) of the electromagnetic conducting or absorbing powder convex structure section and the thickness of the holding part. The thickness of the coating layer can be, for example, selected within a range of from 10 to 5,000 $\mu$m (preferably from 30 to 3,000 $\mu$m, and more preferably from 30 to 2,000 $\mu$m).

In the invention, the coating layer may also be a layer formed by a pressure-sensitive adhesive tape or sheet. More specifically, the coating layer may be formed by adhering a pressure-sensitive adhesive tape or sheet on the surface on which the electromagnetic conducting or absorbing powder convex structure section is exposed. The pressure-sensitive adhesive tape or sheet for forming the coating layer may be a pressure-sensitive adhesive tape or sheet of a construction formed solely of a pressure-sensitive adhesive layer (pressure-sensitive adhesive tape or sheet of base material-less type) or a pressure-sensitive adhesive tape or sheet of a construction having a pressure-sensitive adhesive on one or both surfaces of a base material (pressure-sensitive adhesive tape or sheet of base material-containing type). In this manner, the coating layer may be a layer formed by a pressure-sensitive adhesive layer only, or a layer formed by a laminated member of a pressure-sensitive adhesive layer and a base material. The coating layer formed by the pressure-sensitive adhesive tape or sheet can be formed, not by coating of a coating material composition, but by an application of a pressure-sensitive adhesive tape or sheet onto the electromagnetic conducting or absorbing powder convex structure section and the holding part.

In the case that the coating layer is formed by a pressure-sensitive adhesive tape or sheet of base material-less type or a pressure-sensitive adhesive tape or sheet of base material-containing type, the pressure-sensitive adhesive layer in each pressure-sensitive adhesive tape or sheet may be either a pressure-sensitive adhesive layer without the electromagnetic conducting or absorbing properties (non-electromagnetic conducting or absorbing pressure-sensitive adhesive layer) or a pressure-sensitive adhesive layer with the electromagnetic conducting or absorbing properties (electromagnetic conducting or absorbing pressure-sensitive adhesive layer). In such coating layer, examples of the pressure-sensitive adhesive composition for constructing the non-electromagnetic conducting or absorbing pressure-sensitive adhesive layer in the pressure-sensitive adhesive tape or sheet include those enumerated for the pressure-sensitive adhesive or adhesive layer as the substrate above. On the other hand, examples of the pressure-sensitive adhesive composition for constructing the electromagnetic conducting or absorbing pressure-sensitive adhesive layer in the pressure-sensitive adhesive tape or sheet include the pressure-sensitive adhesive composition containing the electromagnetic conducting or absorbing material, as enumerated as the pressure-sensitive adhesive composition for constructing the pressure-sensitive adhesive or adhesive layer having the electromagnetic conducting or absorbing properties, in the pressure-sensitive adhesive or adhesive layer as the substrate.

In the case that the coating layer is formed by a pressure-sensitive adhesive tape or sheet of base material-containing type, the base material of the pressure-sensitive adhesive tape or sheet may be either a base material with the electromagnetic conducting or absorbing properties (non-electromagnetic conducting or absorbing base material) or a base material with the electromagnetic conducting or absorbing properties (electromagnetic conducting or absorbing base material). In such coating layer, examples of the non-electromagnetic conducting or absorbing base material in the pressure-sensitive adhesive tape or sheet of base material-containing type include a plastic-based base material having electromagnetic conducting or absorbing properties, a paper-based base material having electromagnetic conducting or absorbing properties and a fibrous base material having electromagnetic conducting or absorbing properties, and specific examples thereof include a plastic-based base material, a paper-based base material and a fibrous base material, as enumerated for the base material as the support in the structure. On the other hand, examples of the electromagnetic conducting or absorbing base material in the pressure-sensitive adhesive tape or sheet of base material-containing type include those as enumerated for the base material as the support in the structure (such as a base material constituted of an electromagnetic conducting or absorbing material or a base material containing an electromagnetic conducting or absorbing material on the surface or in the interior).

Specifically, as the pressure-sensitive adhesive tape or sheet for forming the coating layer, employable for example is a pressure-sensitive adhesive tape or sheet without a base material, a pressure-sensitive adhesive tape or sheet utilizing a plastic film or sheet (such as a polyester film or sheet) as the base material, a pressure-sensitive adhesive tape or sheet utilizing a non-woven cloth as the base material, or a pressure-sensitive adhesive tape or sheet utilizing a metal foil (such as an aluminum foil) as the base material. In such pressure-sensitive adhesive tape or sheet, the pressure-sensitive adhesive for constituting the pressure-sensitive adhesive layer can advantageously be an acrylic pressure-sensitive adhesive or a rubber-type pressure-sensitive adhesive, and may contain an electromagnetic conducting or absorbing material.

A forming method for the pressure-sensitive adhesive tape or sheet for forming the coating layer may be suitably selected from publicly known methods for forming the pressure-sensitive adhesive tape or sheet. As the thickness of the pressure-sensitive adhesive tape or sheet naturally becomes the thickness of the coating layer, it is important to regulate the thicknesses of the pressure-sensitive adhesive layer and the base material in the pressure-sensitive adhesive tape or sheet, so as to attain the thickness of the coating layer, described above. Also in the pressure-sensitive adhesive tape or sheet for constructing the coating layer, each of the pressure-sensitive adhesive layer and the base material may have a single-layered structure or a laminated structure. In the case that the coating layer is constituted of a pressure-sensitive adhesive tape or sheet having pressure-sensitive adhesive layers on both surfaces of the base material, such pressure-sensitive adhesive layers formed on both surfaces of the base material may be same or different with each other. Structure

The structure of the invention importantly has, as described above, such a construction that an electromagnetic conducting or absorbing powder convex structure section and a holding part for holding the convex structure of the electromagnetic conducting or absorbing powder convex structure section are formed on a substrate surface, and, within such construction, appropriate layers may be provided in appropriate positions so far as the effect and function of the invention are not affected significantly. Specific examples of the construction of the structure of the invention include following constructions (A) to (D):

(A) A construction in which a pressure-sensitive adhesive layer or an adhesive layer (pressure-sensitive adhesive or adhesive layer) is formed as a substrate on at least a surface (on one surface or both surfaces) of a base material as a support for supporting the substrate, and, on the pressure-sensitive adhesive or adhesive layer on at least a surface (on one surface or both surfaces) of the base material, an electromagnetic conducting or absorbing powder convex structure section and a holding part are formed;

(B) A construction in which a pressure-sensitive adhesive layer is formed as a substrate on a releasing surface of a release liner for supporting the substrate, and, on the pressure-sensitive adhesive layer on a surface of the release liner, an electromagnetic conducting or absorbing powder convex structure section and a holding part are formed;

(C) A construction in which a substrate is not supported by a support, and, on at least a surface (one surface or both surfaces) of a pressure-sensitive adhesive layer or a polymer layer as the substrate, an electromagnetic conducting or absorbing powder convex structure section and a holding part are formed;

(D) A construction in which, in the foregoing constructions (A) to (C), the holding part is formed by a member having a penetrating hole section, and the surface of the electromagnetic conducting or absorbing powder convex structure section and the holding part is covered by a coating layer [stated differently, a construction in which a substrate is supported when necessary by a support (such as a base material or a release liner), and, on at least a surface (one surface or both surfaces) of a pressure-sensitive adhesive or adhesive layer or a polymer layer as the substrate, an electromagnetic conducting or absorbing powder convex structure section and a holding part are formed, and the surface of the electromagnetic conducting or absorbing powder convex structure section and the coating layer is covered by a coating layer].

As the structure, also usable is a structure of a construction in which at least two structures, selected from the foregoing constructions (A) to (D), are superposed in plural stages.

The electromagnetic conducting or absorbing powder convex structure sections formed on both surfaces of the substrate may be same electromagnetic conducting or absorbing powder convex structure sections each other or different electromagnetic conducting or absorbing powder convex structure sections from each other. Also the coating layers covering the respective electromagnetic conducting or absorbing powder convex structure sections may be same coating layers each other or different coating layers from each other. Further, the pressure-sensitive adhesive layers formed on both surfaces of the substrate may be same pressure-sensitive adhesive layers each other or different pressure-sensitive adhesive layers from each other.

Furthermore, in the case that the structure has the electromagnetic conducting or absorbing powder convex structure section on one surface only, the other surface of the structure may be formed as a pressure-sensitive adhesive surface or an adhesive surface either entirely or partially (for example at least in either one end portion). In the case that the surface of the structure is formed as a pressure-sensitive adhesive surface or an adhesive surface, such pressure-sensitive adhesive surface or adhesive surface may be either of a pressure-sensitive adhesive surface or an adhesive surface formed by a pressure-sensitive adhesive layer or an adhesive layer having the electromagnetic conducting or absorbing properties and a pressure-sensitive adhesive surface or an adhesive surface formed by a pressure-sensitive adhesive layer or an adhesive layer not having the electromagnetic conducting or absorbing properties, but is preferably a pressure-sensitive adhesive surface or an adhesive surface formed by a pressure-sensitive adhesive layer or an adhesive layer having the electromagnetic conducting or absorbing properties. Also in the case that the structure has a construction in which the electromagnetic conducting or absorbing powder convex structure section and the holding part, formed by a member having a penetrating hole section, are covered by a coating layer, the surface of the coating layer may be formed as a pressure-sensitive adhesive surface or an adhesive surface either entirely or partially (for example at least in either one end portion). In such case that the structure is provided with a coating layer of which surface is formed as a pressure-sensitive adhesive surface or an adhesive surface, such pressure-sensitive adhesive surface or adhesive surface may be either of a pressure-sensitive adhesive surface or an adhesive surface formed by a pressure-sensitive adhesive layer or an adhesive layer having the electromagnetic conducting or absorbing properties, and a pressure-sensitive adhesive surface or an adhesive surface formed by a pressure-sensitive adhesive layer or an adhesive layer not having the electromagnetic conducting or absorbing properties. Such pressure-sensitive adhesive surface or adhesive surface can be formed, for example, by a method of utilizing a known pressure-sensitive adhesive or a known adhesive, or by a method of utilizing a known double-sided pressure-sensitive adhesive tape. Therefore, in the case that the surface of the structure is formed as a pressure-sensitive adhesive surface or an adhesive surface, a structure having a pressure-sensitive adhesive surface or an adhesive surface on a surface thereof can be prepared, for example, by a method of employing a support (base material) of which an externally exposed surface is formed in advance as a pressure-sensitive adhesive surface or an adhesive surface, a method of coating a pressure-sensitive adhesive or an adhesive on a surface of a support (base material) of which an externally exposed surface is not formed as a pressure-sensitive adhesive surface or an adhesive surface, a method of applying a double-sided pressure-sensitive adhesive tape or sheet (a double-sided pressure-sensitive adhesive tape or sheet of base material-less type or a double-sided pressure-sensitive adhesive tape or sheet of base material-including type) on a surface of a support (base material) of which an externally exposed surface is not formed as a pressure-sensitive adhesive surface or an adhesive surface, a method of employing a pressure-sensitive adhesive tape or sheet of which an externally exposed surface is formed in advance as a pressure-sensitive adhesive surface or an adhesive surface, a method of coating a pressure-sensitive adhesive or an adhesive on a surface of a coating layer of which an externally exposed surface is not formed as a pressure-sensitive adhesive surface or an adhesive surface, or a method of applying a double-sided pressure-sensitive adhesive tape or sheet (a double-sided pressure-sensitive adhesive tape or sheet of base material-less type or a double-sided pressure-sensitive adhesive tape or sheet of base material-including type) on a surface of a coating layer of which an externally exposed surface is not formed as a pressure-sensitive adhesive surface or an adhesive surface.

The present invention, even in the case that the electromagnetic conducting or absorbing powder convex structure section and the holding part, formed by the member having the penetrating hole section, are covered by a coating layer and the coating layer contains or is formed as an insulating layer (for example an electrically non-conductive member such as an electrically non-conductive pressure-sensitive adhesive or adhesive layer constituting the pressure-sensitive adhesive or adhesive surface), can suppress or prevent a loss in the electromagnetic conducting or absorbing properties, and can effectively retain and exhibit the electromagnetic conducting or absorbing properties (in particular electromagnetic shielding property for shielding electromagnetic waves by conduction or absorption). In the present invention, when the structure includes a coating layer, the surface thereof is preferably formed as an insulating layer. Such insulating layer can be formed, for example, by a method of employing a pressure-sensitive adhesive tape or sheet of base material-containing type utilizing a non-electromagnetic conducting or absorbing base material (particularly a plastic base material not having the electromagnetic conducting or absorbing properties), or a method of applying a pressure-sensitive adhesive tape or sheet of base material-containing type utilizing a non-electromagnetic conducting or absorbing base material (particularly a plastic base material not having the electromagnetic conducting or absorbing properties) onto the surface of the coating layer.

Such structure, when the electromagnetic conducting or absorbing powder convex structure sections are formed on both surfaces of the substrate, can further increase the electromagnetic conducting or absorbing properties, so that the base material supporting the substrate may be formed with a smaller thickness or may be dispensed with, thereby reducing the weight of the structure and improving flexibility and adaptability (adaptability to an adhered member).

The structure of the invention is not particularly limited with respect to the form so far as it has the foregoing constructions. Concretely, the structure may have a form of every kind such as spherical, cylindrical, polygonal, polygonal conical, conical, tabular, and sheet-like forms. Of these, a sheet-like form is preferable. That is, it is preferable that the structure of the invention is a sheet-like structure having a sheet-like form. Incidentally, the sheet-like structure can have not only electromagnetic conducting or absorbing properties but also pressure-sensitive adhesive or adhesive property (in particular, pressure-sensitive adhesive property). For example, in the case where the sheet-like structure has pressure-sensitive adhesive property, the sheet-like structure may have a form of a pressure-sensitive adhesive tape or sheet in which, on a side thereof not bearing the electromagnetic conducting or absorbing powder convex structure section, the surface of the pressure-sensitive adhesive layer is formed as a pressure-sensitive adhesive surface.

Incidentally, in the case where the structure is a sheet-like structure, the subject sheet-like structure can be prepared in form wound into a roll or in a single-layered or stacked form. Therefore, the structure of the invention, in the case of a sheet-like structure, can be made into a product as the structure of a form wound into a roll or of a form of a single sheet or a stack of sheets.

As the structure of the invention has a construction in which the electromagnetic conducting or absorbing powder convex structure section is formed on the substrate surface and is capable of effectively exhibiting the electromagnetic conducting or absorbing properties by the electromagnetic conducting or absorbing powder convex structure section, it can be used in a variety of applications utilizing electromagnetic conducting or absorbing properties by the electromagnetic conducting or absorbing powder convex structure section. For example, it can be advantageously utilized in applications utilizing for example an electric conductivity of conducting or passing an electric current, a property of conducting electromagnetic waves (electromagnetic conducting property), a property of absorbing electromagnetic waves (electromagnetic absorbing propeerty), an electromagnetic shielding property of shielding electromagnetic waves by conduction or by absorption, or an electrostatic removing property of removing an electrostatic charge by a conduction. Specifically, the structure of the invention can be advantageously utilized as an electric conductive material capable of conducting or passing electricity, an electromagnetic wave conductive material capable of conducting electromagnetic waves, an electromagnetic absorbing material capable of absorbing electromagnetic waves, an electromagnetic shielding material capable of shielding electromagnetic waves, or an electrostatic removing material capable of removing a static thereby preventing static generation (or an electrostatic hindrance preventing material capable of preventing various hindrances by static), and can be utilized particularly advantageously as an electric conductive material, an electromagnetic absorbing material or an electromagnetic shielding material.

Specifically, the structure of the invention, when employed as an electromagnetic shielding material, can be utilized as an electromagnetic shielding material for a wire covering (particularly electromagnetic shielding material for automotive wires), an electromagnetic shielding material for electronic components, an electromagnetic shielding material for clothing and an electromagnetic shielding material for buildings. The structure of the invention, when employed as an electromagnetic shielding material for a wire covering, can be used for shielding the electromagnetic waves generated from the wire, thereby suppressing or preventing noises from the wire. The structure of the invention, when employed as an electromagnetic shielding material for an electronic component, can be used for shielding the electromagnetic waves from the exterior to the electronic component (for example an electronic circuit board or an electronic equipment equipped with an electronic circuit board), thereby suppressing or preventing noises to the electronic component. Also the structure of the invention, when employed as an electromagnetic shielding material for a clothing, can be used for shielding the electromagnetic waves generated from a computer, those from electric cooling equipment, and those from medical equipment (such as so-called "MRI" equipment, so-called "CT-scanner" equipment or so-called "X-ray imaging" equipment), thereby suppressing or preventing electromagnetic influences to the human body. Furthermore, the structure of the invention, when employed as an electromagnetic shielding material for a building, can be used for shielding the electromagnetic waves generated from the interior of the building, thereby suppressing or preventing information leak, and for shielding the electromagnetic waves from the exterior to the building, thereby inhibiting use of so-called "mobile phone" or preventing detrimental influence by FM waves (radio waves) (for example preventing erroneous function of wireless microphone) in buildings used for various purposes (such as a movie theater, a concert hall, a drama theater, a museum, an art museum, a wedding hall, or a meeting or lecture hall) or a room (for example meeting room) in the building.

Further, the structure of the invention, when employed as an electromagnetic absorbing material, can be used as an electromagnetic absorbing material for a building. Specifically, in the case that the structure of the invention is used as an electromagnetic absorbing material for a building, it may be adhered to a partitioning member of a room (for example a member constituting a ceiling surface, a wall surface or a floor surface) for the purpose of suppressing or preventing a scattering or a random reflection of electromagnetic waves emitted from an electronic equipment installed inside the room, thereby avoiding an erroneous operation or ensuring an efficient function of the various electronic equipment installed inside the room.

In the structure of the invention, as the electromagnetic conducting or absorbing powder constituting the electromagnetic conducting or absorbing powder convex structure section, there may be employed plural (two or more) electromagnetic conducting or absorbing powders (for example plural (two or more) electromagnetic conducting or absorbing raw material powders or plural (two or more) electromagnetic conducting or absorbing property-imparted powders such as electromagnetic conducting or absorbing material-coated powders or electromagnetic conducting or absorbing material-impregnated powders utilizing different metal materials as the electromagnetic conducting or absorbing materials), or by employing even a single electromagnetic conducting or absorbing powder utilizing plural (two or more) electromagnetic conducting or absorbing materials (for example an electromagnetic conducting or absorbing property-imparted powder such as an electromagnetic conducting or absorbing material-coated powder or an electromagnetic conducting or absorbing material-impregnated powder utilizing plural (two or more) electromagnetic conducting or absorbing materials), whereby it becomes possible to effectively exhibit a shielding function against not only electromagnetic waves having a single peak wavelength but also electromagnetic waves having plural peak wavelengths. Thus, as the electromagnetic conducting or absorbing powder constituting the electromagnetic conducting or absorbing powder convex structure section, by combining plural electromagnetic conducting or absorbing powders and by suitably regulating the proportion thereof, it is possible to effectively shield electromagnetic waves by a single structure (electromagnetic shielding material) against a radiation source such as a material and a substance, from which plural electromagnetic waves having various peak lengths are emitted in a prescribed proportion. Thus, the structure of the invention, when employed as an electromagnetic shielding material, can be easily prepared in a construction capable of exhibiting a shielding function not restricted by the type of radiation source emitting electromagnetic waves and effective against radiation sources of a wide range. Therefore the present invention enables to easily obtain an electromagnetic shielding material capable of a shielding by more effectively conducting or absorbing the electromagnetic waves.

Specifically, in the case where an electromagnetic conducting or absorbing properties-imparted powder is used as the electromagnetic conducting or absorbing powder, within metal materials as the electromagnetic conducting or absorbing material for constructing the electromagnetic conducting or absorbing properties-imparted powder, for example, nickel and gold are different in the type or wavelength of electromagnetic waves to be shielded by conduction or absorption. Accordingly, for example, when a nickel plated powder and a gold plated powder are used for forming an electromagnetic conducting or absorbing powder convex structure section, the resulting electromagnetic shielding material can efficiently exhibit an electromagnetic shielding effect by nickel and an electromagnetic shielding effect by gold, respectively, thereby enabling one to effectively shield electromagnetic waves.

In addition, in the structure of the invention, by properly adjusting the thickness of the electromagnetic conducting or absorbing powder convex structure section, the density of the electromagnetic conducting or absorbing powder in the electromagnetic conducting or absorbing powder convex structure section, as well as the type of the electromagnetic conducting or absorbing powder for forming the electromagnetic conducting or absorbing powder convex structure section, the structure of the invention can be made to serve as a structure capable of exhibiting the desired or adequate electrical conductivity and electromagnetic shielding properties.

Incidentally, for the purpose of further conducting or absorbing electromagnetic waves, the structure of the invention may be grounded.

Furthermore, the structure of the invention can be used in various applications utilizing various characteristics such as soundproofing, thermal conductivity, light reflection properties, and design properties as well as various applications utilizing electromagnetic conducting or absorbing properties.

The structure of the invention is not particularly restricted in the producing method therefor, and, for example in case of employing a member having a penetrating hole section as the holding part-constituting member, there is preferred a method of adhering the member having the penetrating hole section on a substrate surface to form a holding part, then introducing a powder having electromagnetic conducting or absorbing properties into the penetrating hole section of the member having the penetrating hole section thereby forming a powder convex structure section having electromagnetic conducting or absorbing properties, and covering the surface on which the electromagnetic conducting or absorbing powder convex structure section is exposed, with a coating layer. Also in case of employing a member having a concave as the holding part-constituting member, there is preferred a method of introducing a powder having electromagnetic conducting or absorbing properties into the concave of the member having the concave thereby forming a powder convex structure section having electromagnetic conducting or absorbing properties, and covering the surface on which the electromagnetic conducting or absorbing powder convex structure section is exposed, with a substrate.

Also a method of adhering the holding part-constituting member on the substrate surface is not particularly limited, and there may be employed fixing means suitably selected from the known fixing means, according to the type of the substrate and the type of the holding part-constituting member. Specifically, in the case that the substrate is a pressure-sensitive adhesive or adhesive layer, the holding part-constituting member can be applied to a prescribed site on the surface of the pressure-sensitive adhesive or adhesive layer as the substrate. Also in the case that the substrate is a polymer layer, the holding part-constituting member can be applied to a prescribed site on the surface of the polymer layer as the substrate, by fixing means utilizing a pressure-sensitive adhesive or an adhesive or fixing means of forming a pressure-sensitive adhesive or adhesive layer on the surface of the holding part-constituting member.

A position for forming the electromagnetic conducting or absorbing powder convex structure section on the substrate surface, and a size and a number of the electromagnetic conducting or absorbing powder convex structure section can be controlled by a position of forming a penetrating hole section or a concave section in the holding part-constituting member and a size and a number of the penetrating hole section or the concave section in the holding part-constituting member.

In the invention, the electromagnetic conducting or absorbing properties (in particular, the electrical conductivity) of the structure can be evaluated by measuring a volume specific resistance according to JIS K6705. The electromagnetic conducting or absorbing properties of the structure can be controlled depending upon the size of the respective electromagnetic conducting or absorbing powder convex structure section which is formed on the substrate (area occupied by one electromagnetic conducting or absorbing powder convex structure section) and the shape thereof, the proportion of the whole electromagnetic conducting or absorbing powder convex structure section formed on the substrate with respect to the entire surface of the substrate (the proportion of the occupied area of the whole electromagnetic conducting or absorbing powder convex structure section), the shape (height and cross-sectional area) of the electromagnetic conducting or absorbing powder convex structure section and raw material thereof.

Examples

The invention will be described below in detail with reference to the following Examples, but the invention is not limited to these Examples.

Example 1

On one surface of an aluminum base material (thickness: 50 μm) as an electromagnetic conducting or absorbing base material, an acrylic pressure-sensitive adhesive (base polymer: butyl acrylate-acrylic acid copolymer) containing 35% by weight (proportion based on the whole amount of solids) of a nickel powder blended therein was coated in a thickness after drying of 35 μm to form an electromagnetic conducting or absorbing pressure-sensitive adhesive layer. Then, on the electromagnetic conducting or absorbing pressure-sensitive adhesive layer, a net-like member "Nisseki Conwood ON6200 (trade name)" (manufactured by Nisseki Plasto Co., pore size: 4 x 4 mm, weight: 34 g/m$^2$, pore rate: 76 %, thickness: 0.5 mm) was adhered to form a holding part for holding the convex structure of the electromagnetic conducting or absorbing powder convex structure section. Subsequently, a copper powder (trade name "Cu-HWQ 5μm", manufactured by Fukuda Metal Foil Powder Co.) was introduced into the penetrating hole section of the net-like member, and was leveled off at the surface of the net-like member in such a manner that the height of the heap of the copper powder becomes approximately equal to the height of the net-like member, thereby forming a electromagnetic conducting or absorbing powder convex structure section. Thereafter, onto the upper surface of the electromagnetic conducting or absorbing powder convex structure section and the holding part, a polyethylene terephthalate film (film thickness: 24 μm) having an acrylic pressure-sensitive adhesive layer (thickness: 24 μm) on one side was adhered to form a coating layer (cover), thereby preparing a sheet-like structure (also called "sheet-like structure A1") of a construction in which, on an electromagnetic conducting or absorbing pressure-sensitive adhesive layer formed on an electromagnetic conducting or absorbing base material, a convex structure of an electromagnetic conducting or absorbing powder (electromagnetic conducting or absorbing powder convex structure section) is formed partially and the convex structure of the electromagnetic conducting or absorbing powder convex structure section is held by the holding part.

Comparative Example 1

On one surface of an aluminum base material (thickness: 50 μm) as an electromagnetic conducting or absorbing base material, an acrylic pressure-sensitive adhesive (base polymer: butyl acrylate-acrylic acid copolymer) containing 35% by weight (proportion based on the whole amount of solids) of a nickel powder blended therein was coated in a thickness after drying of 35 μm to form an electromagnetic conducting or absorbing pressure-sensitive adhesive layer. Then, on the electromagnetic conducting or absorbing pressure-sensitive adhesive layer, a net-like member "Nisseki Conwood ON6200 (trade name)" (manufactured by Nisseki Plasto Co., pore size: 4 x 4 mm, weight: 34 g/m$^2$, pore rate: 76 %, thickness: 0.5 mm) was adhered, thereby preparing a sheet-like structure (also called "sheet-like structure A2").

Evaluation

On the sheet-like structures A1 to A2 obtained in Example 1 and Comparative Example 1, a magnetic shielding effect was evaluated by an electromagnetic shielding evaluation system by the KEC method. The evaluation results are shown in Table 1.

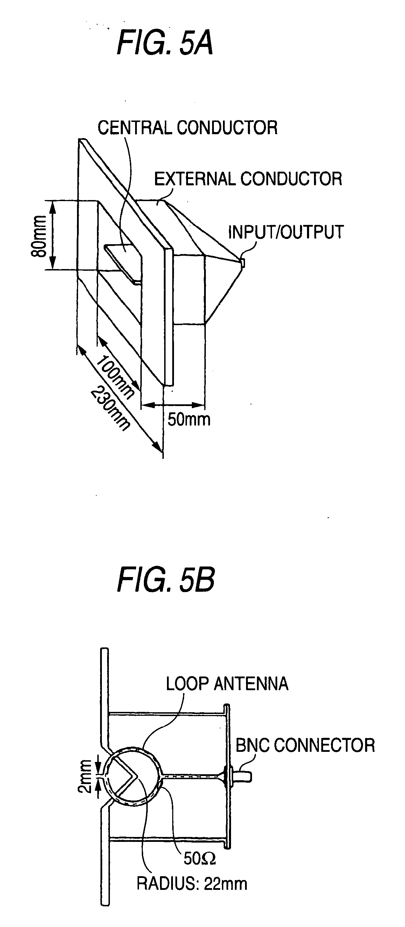

Incidentally, the KEC method in the electromagnetic shielding evaluation system by the KEC method is a method developed by Kansai Electronic Industry Development Center. According to this method, the shielding effect in a near electromagnetic field is evaluated by using an amplifier, a spectrum analyzer and respective shielding boxes (an electrical field shielding box and a magnetic field shielding box) marketed from Anritsu Corp. Concretely, by using an electrical field shielding box as shown in Fig. 5A or a magnetic field shielding box as shown in Fig. 5B, the sheet-like structure is placed in a prescribed position; an electromagnetic wave having a prescribed frequency (MHz) (incident wave: incident electrical field or incident magnetic field) is made incident with a prescribed energy (hereinafter also represented as "E1") from the side of the electromagnetic conducting or absorbing powder convex structure section of the sheet-like structure; an energy (hereinafter also represented as "E2") of a transmitted wave (transmitted electrical field or transmitted magnetic field) which has transmitted into the other surface of the sheet-like structure is measured; and the shielding effect (dB) is determined according to the following formula (1).

$$\text{Shielding effect (dB)} = 20 \times \log (E2/E1) \qquad (1)$$

Figs. 5A and 5B each is an outline view illustrating a shielding box to be used in the electromagnetic shielding evaluation system by the KEC method; and Fig. 5A shows an electrical field shielding box, while Fig. 5B shows a magnetic field shielding box. The electrical field shielding box (unit for electrical field shielding evaluation) has a structure in which dimensional distribution of a TEM cell is employed and the inside of the plane vertical to the transmission axis direction is bisected symmetrically in the lateral direction. However, a shortcircuit formation is prevented by the insertion of a measurement sample. Also the magnetic field shielding box (unit for magnetic field shielding evaluation) has a structure in which a shielded circular loop antenna is used for generating an electromagnetic field of a large magnetic field component and is combined with a metal plate having a 90° angle in such a manner that a 1/4 portion of the loop antenna is exposed externally.

Incidentally, the shielding effect is described in detail in Denjiha Shahei Gijutsu (Electromagnetic Shielding Technologies) (pages 253 to 269) in Tokkyo Mappu Shirizu: Denki 23 (Patent Map Series: Electricity 23) published by Japan Institute of Invention and Innovation, etc. In this reference, it is described that the shielding effect is an index to what extent the electromagnetic energy of the incident electrical field or incident magnetic field can be attenuated, and the shield effect is expressed as a value of 20 times of a common logarithm of a ratio of the electromagnetic energy of the transmitted electrical field or transmitted magnetic field to the electromagnetic energy of the incident electrical field or incident magnetic field (unit: dB). Also, with respect to the shielding effect, it is described (on pages 253 to 254) that as criteria of the shield effect, the shielding effect is scarce at from 0 to 10 dB; the shielding effect is minimum at from 10 to 30 dB; the shielding effect is at an average level at from 30 to 60 dB; the shielding effect is considerably revealed at from 60 to 90 dB; and the shielding effect is highest at 90 dB or more.

In the foregoing KEC method, a measurement limit is different in the low frequency region and in the high frequency region. This is because a transmission characteristic of shielding (aluminum shielding plate) is constant regardless of the frequency (-105 dBm from 1 MHz to 1 GHz in the electrical field shielding box), while a through-transmission characteristic has a frequency characteristic (reception level being attenuated by about -50 dBm in the low frequency side, whereas reception level at the high frequency side being substantially same as in the transmitting side with attenuation of 0 dBm). Incidentally, it is thought that the transmission characteristic of shield (2 mm-thick aluminum shielding plate) is actually a much smaller value and that -105 dBm is a noise level (ability) of the spectrum analyzer. Also it is thought that if the noise level (ability) of the spectrum analyzer is made better, the transmission characteristic of shielding (aluminum shielding plate) becomes further smaller, and a difference from the through-transmission is made larger, whereby the measurement limit can be expanded. However, when expressed in terms of electrical power, -105 dBm is in fact a very small value as not more than 0.1 pW, it is considered that a further improvement will be difficult.

Table 1

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit | 57 | 63 | 66 | 71 | 74 | 77 | 83 | 86 | 90 | 92 | 95 | 98 | 100 | 97 | 93 | 75 |
| Example 1 | 32 | 38 | 42 | 47 | 50 | 54 | 65 | 70 | 90 | 85 | 86 | 92 | 94 | 97 | 93 | 75 |
| Comp. Ex. 1 | 32 | 36 | 41 | 46 | 49 | 53 | 62 | 63 | 64 | 65 | 67 | 73 | 75 | 76 | 80 | 75 |

As will be apparent from Table 1, it was confirmed that the sheet-like structure A1 of Example 1 was significantly superior in the magnetic field shielding effect, in comparison with the sheet-like structure A2 of Comparative Example 1.

It is naturally evident also that the sheet-like structure A1 of Example 1 was excellent also in the electric field shielding effect.

While the invention has been described in detail and with reference to specific embodiments thereof, it will be apparent to one skilled in the art that various changes and modifications can be made therein without departing from the scope thereof.

This application is based on Japanese patent application No. 2006-126183 filed April 28, 2006, the entire contents thereof being hereby incorporated by reference.

Further, all references cited herein are incorporated in their entireties.


**Claims**

1. A structure having a characteristic of conducting or absorbing electromagnetic waves, which comprises:

   a substrate;
   a powder material convex structure section having a characteristic of conducting or absorbing electromagnetic waves disposed on a surface of the substrate, said powder material convex structure section containing a powder material having a characteristic of conducting or absorbing electromagnetic waves and being formed so as to have a convex structure; and
   a holding part disposed on a surface of the substrate, said holding part holding the convex structure of the powder material convex structure section having a characteristic of conducting or absorbing electromagnetic waves.

2. The structure according to claim 1, having a construction in which the powder material convex structure section having a characteristic of conducting or absorbing electromagnetic waves and the holding part are formed on a surface of the substrate, which is formed by adhering a member having a penetrating hole section on the surface of the substrate thereby forming the holding part; then introducing the powder material having a characteristic of conducting or absorbing electromagnetic waves into the penetrating hole section of the member having a penetrating hole section, thereby forming the powder material convex structure section having a characteristic of conducting or absorbing electromagnetic waves; and then covering, with a coating layer, the surface on which the powder material convex structure section having a characteristic of conducting or absorbing electromagnetic waves is exposed.

3. The structure according to claim 2, wherein the member having a penetrating hole section is a member having a plurality of penetrating hole sections in a net-like form, or a sheet-like member having a plurality of penetrating hole sections formed by perforation.

4. The structure according to claim 1, having a construction in which the powder material convex structure section having a characteristic of conducting or absorbing electromagnetic waves and the holding part are formed on a surface of the substrate, which is formed by introducing the powder material having a characteristic of conducting or absorbing electromagnetic waves into a concave of a member having a concave employed as the holding part, thereby forming the powder material convex structure section having a characteristic of conducting or absorbing electromagnetic waves; and then covering, with the substrate, the surface on which the powder material convex structure section having a characteristic of conducting or absorbing electromagnetic waves is exposed.

5. The structure according to claim 1, wherein the holding part includes a plastic material.

6. The structure according to claim 1, wherein a total area of a portion of the surface of the substrate on which the powder material convex structure section having a characteristic of conducting or absorbing electromagnetic waves is formed has a proportion more than 0% but equal to or less than 99.9% with respect to a total surface area of one side of the substrate.

7. The structure according to claim 1, wherein the substrate is at least one member selected from the group consisting of a pressure-sensitive adhesive layer, an adhesive layer and a polymer layer.

8. The structure according to claim 1, wherein the substrate has a characteristic of conducting or absorbing electromagnetic waves.

9. The structure according to claims 1, wherein the substrate is formed on at least one surface of a support.

10. The structure according to claim 9, wherein the support has a characteristic of conducting or absorbing electromagnetic waves.

11. The structure according to claim 1, which is a sheet-like structure having a sheet-like form.

12. The structure according to claim 1, which is used as an electrically conductive member.

13. The structure according to claim 1, which is used as an electromagnetic absorbing member.

14. The structure according to claim 1, which is used as an electromagnetic shielding member.

## FIG. 1

## FIG. 2A

## FIG. 2B

## FIG. 3

## FIG. 4A

## FIG. 4B

## FIG. 4C

# FIG. 5A

CENTRAL CONDUCTOR

EXTERNAL CONDUCTOR

INPUT/OUTPUT

80mm

100mm

230mm

50mm

# FIG. 5B

LOOP ANTENNA

BNC CONNECTOR

2mm

50Ω

RADIUS: 22mm

European Patent
Office

**EUROPEAN SEARCH REPORT**

Application Number

EP 07 00 8574

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 95/18476 A (MINNESOTA MINING & MFG [US]) 6 July 1995 (1995-07-06)<br>* abstract *<br>* figures 1,2 *<br>* page 2, paragraph 5 - page 5, paragraph 1 * | 1-8, 11-14 | INV.<br>H01Q17/00<br>H01R4/04<br>H05K9/00 |
| Y | DE 25 24 300 A1 (TDK ELECTRONICS CO LTD) 11 December 1975 (1975-12-11)<br>* page 1, paragraph 1 - page 3, paragraph 4 * | 1-8, 11-14 | |
| Y | WO 2006/022463 A (JOINSET CO LTD [KR]; KIM SUN-KI [KR]) 2 March 2006 (2006-03-02)<br>* abstract *<br>* figure 2 *<br>* page 1, line 1 - page 3, line 24 * | 12-14 | |
| A | EP 1 494 520 A (DAIDO STEEL CO LTD [JP]) 5 January 2005 (2005-01-05)<br>* abstract *<br>* paragraph [0007] - paragraph [0008] * | 1-14 | |
| | | | TECHNICAL FIELDS SEARCHED (IPC) |
| A | US 5 103 231 A (NIIOKA YOSHIO [JP]) 7 April 1992 (1992-04-07)<br>* abstract *<br>* figures 1-4,9-11 *<br>* column 2, paragraph 2 - paragraph 3 * | 1-14 | H01Q<br>H05K<br>H01R |
| A | EP 0 877 394 A1 (TOKIN CORP [JP] NEC TOKIN CORP [JP]) 11 November 1998 (1998-11-11)<br>* abstract *<br>* page 2, lines 35-43 *<br>* figures 1-4 * | 1-14 | |

The present search report has been drawn up for all claims

| Place of search | Date of completion of the search | Examiner |
|---|---|---|
| The Hague | 16 August 2007 | Hüschelrath, Jens |

EPO FORM 1503 03.82 (P04C01)

**ANNEX TO THE EUROPEAN SEARCH REPORT
ON EUROPEAN PATENT APPLICATION NO.**                EP 07 00 8574

This annex lists the patent family members relating to the patent documents cited in the above-mentioned European search report.
The members are as contained in the European Patent Office EDP file on
The European Patent Office is in no way liable for these particulars which are merely given for the purpose of information.

16-08-2007

| Patent document cited in search report | | Publication date | Patent family member(s) | | Publication date |
|---|---|---|---|---|---|
| WO 9518476 | A | 06-07-1995 | CN | 1139499 A | 01-01-1997 |
| | | | DE | 69427371 D1 | 05-07-2001 |
| | | | DE | 69427371 T2 | 25-04-2002 |
| | | | EP | 0737375 A1 | 16-10-1996 |
| | | | JP | 3339863 B2 | 28-10-2002 |
| | | | JP | 9507113 T | 15-07-1997 |
| | | | US | 5443876 A | 22-08-1995 |
| | | | US | 5522962 A | 04-06-1996 |
| DE 2524300 | A1 | 11-12-1975 | JP | 50155999 A | 16-12-1975 |
| | | | US | 4003840 A | 18-01-1977 |
| WO 2006022463 | A | 02-03-2006 | NONE | | |
| EP 1494520 | A | 05-01-2005 | CN | 1577635 A | 09-02-2005 |
| | | | US | 2005030217 A1 | 10-02-2005 |
| US 5103231 | A | 07-04-1992 | JP | 3114295 A | 15-05-1991 |
| EP 0877394 | A1 | 11-11-1998 | CN | 1199496 A | 18-11-1998 |
| | | | DE | 69737349 T2 | 31-05-2007 |
| | | | WO | 9809301 A1 | 05-03-1998 |
| | | | JP | 10074613 A | 17-03-1998 |
| | | | TW | 388153 B | 21-04-2000 |
| | | | US | 6723914 B1 | 20-04-2004 |

EPO FORM P0459

For more details about this annex : see Official Journal of the European Patent Office, No. 12/82

**REFERENCES CITED IN THE DESCRIPTION**

**Patent documents cited in the description**

- JP 2002501821 T
- JP 10120904 A
- JP 61002394 A
- JP 2006126183 A

**Non-patent literature cited in the description**

- Denjiha Shahei Gijutsu (Electromagnetic Shielding Technologies. Tokkyo Mappu Shirizu: Denki 23 (Patent Map Series: Electricity 23. Japan Institute of Invention and Innovation, 253-269